# EUROPEAN PATENT APPLICATION

(11) **EP 4 435 517 A1**
(43) Date of publication of application: **25.09.2024**
(21) Application number: 22892912.1
(22) Date of filing: 14.11.2022
(51) Int. Cl.: G03F 7/11, C08F 220/18, C08G 59/16

(54) **POLYCYCLIC AROMATIC HYDROCARBON-BASED PHOTO-CURABLE RESIN COMPOSITION**

(30) Priority: 15.11.2021 JP 2021185496
(71) Applicant: Nissan Chemical Corporation, Tokyo 103-6119 (JP)
(72) Inventor: KISHIOKA, Takahiro, Toyama-shi, Toyama 939-2792 (JP); HATTORI Hayato, Toyama-shi, Toyama 939-2792 (JP); MORIYA Shunsuke, Toyama-shi, Toyama 939-2792 (JP)
(74) Representative: Müller-Boré & Partner Patentanwälte PartG mbB
(86) International application number: PCT/JP2022/042164
(87) International publication number: WO 2023/085414

(57) **Abstract**

Provided is a photo-curable resin composition that is useful for the formation of a wafer edge part protection film for use in the production of a semiconductor. The photo-curable resin composition comprises: a compound containing a polycyclic aromatic hydrocarbon group derived from naphthalene , anthracene, phenanthrene, pyrene or the like and/or a polymer such as polyvinyl alcohol, polyacrylamide, a (meth)acrylic resin, polyamic acid, polyhydroxystyrene, a polyhydroxystyrene derivative, a copolymer of a polymethacrylate and maleic anhydride, an epoxy resin, a phenolic resin, a novolac resin, polyimide, cellulose, a cellulose derivative, starch, chitin, chitosan, gelatin, zein, a sugar-backbone polymeric compound, polyamide, polyethylene terephthalate, a polycarbonate, polyurethane, polysiloxane or the like; and a solvent. The composition has a viscosity of 100 cps or less at 25°C and is cured with light having a wavelength of 170 to 800 nm.

## Description

### Technical Field

The present invention relates to a photocurable resin composition useful in a lithography process in manufacturing a semiconductor, particularly useful for forming a wafer edge protective film for manufacturing a semiconductor.

In addition, the present invention relates to a photocured film of the composition, particularly a wafer edge protective film for manufacturing a semiconductor, a wafer for manufacturing a semiconductor including the photocured film, and a laminated substrate and a method for manufacturing a semiconductor device using the photocurable resin composition.

### Background Art

Conventionally, in manufacturing a semiconductor device, fine processing by lithography using a resist composition has been performed. The fine processing is a processing method for forming a thin film of a photoresist composition on a semiconductor substrate such as a silicon wafer, irradiating the thin film with active rays such as ultraviolet rays through a mask pattern in which a pattern of a device is formed, performing development, and etching the substrate using the obtained photoresist pattern as a protective film, thereby forming fine unevenness corresponding to the pattern on a surface of the substrate. In recent years, a degree of integration of a semiconductor device has been increased, and in addition to an i-line (wavelength: 365 nm), a KrF excimer laser (wavelength: 248 nm), and an ArF excimer laser (wavelength: 193 nm) that have been used in the related art, active rays used for practical application of an extreme ultraviolet ray (EUV, wavelength: 13.5 nm) or an electron beam (EB) have been studied for the state-of-the-art fine processing. Accordingly, the influence of the semiconductor substrate on the resist becomes a major problem.

Therefore, in order to solve this problem, a method for providing an anti-reflective film (bottom anti-reflective coating (BARC)) or a resist underlayer film between the resist and the semiconductor substrate has been widely studied.

In addition, in manufacturing a semiconductor device, in accordance with complication of a manufacturing process, a method for applying a chemical solution containing a metal to a wafer has been studied for the purpose of, for example, improving an etching selection ratio. Furthermore, for example, since a resolution of a resist pattern in a case of performing exposure using an extreme ultraviolet ray (EUV) is increased and high etching resistance is exhibited, it has been studied to form a resist film using a resist containing an inorganic metal. Adhesion of the metal to a nontargeted portion of the wafer in the manufacturing process of the semiconductor device greatly affects the electrical properties of the semiconductor device. However, in forming a coating film containing a metal as mentioned above, the chemical solution supplied to a front surface of the wafer flows around to a peripheral edge surface and a peripheral edge of a back surface of the wafer, and the coating film is formed even to an unintentional peripheral edge surface and back surface peripheral edge, such that there is a concern that these portions are metal-contaminated. Then, when the contaminated portion of such a wafer comes into contact with a processing device of the wafer such as an exposure device or an etching device or with a conveyance mechanism of the wafer, the wafers that are consecutively conveyed and processed following the contaminated wafer processed through the processing device or conveyance mechanism may also be metal-contaminated, that is, cross-contamination may occur.

In forming a coating film on a front surface of a substrate, a technique in which the coating film can be formed so that a peripheral edge surface, which is a peripheral edge of the substrate and a back surface peripheral edge, does not come into contact with the coating film is disclosed (Patent Literature 1).

A method for manufacturing a semiconductor device, in which release of a film from a bevel portion of a substrate is suppressed, is disclosed (Patent Literature 2).

### Citation List

### Patent Literature

Patent Literature 1: JP 2017-098333 A
Patent Literature 2: JP 2011-228340 A

### Summary of Invention

### Technical Problem

An object of the present invention is to provide a photocurable resin composition useful in a lithography process in manufacturing a semiconductor, particularly useful for forming a wafer edge protective film for manufacturing a semiconductor.

In addition, the present invention is to provide a photocured film of the composition, particularly a wafer edge protective film for manufacturing a semiconductor, a wafer for manufacturing a semiconductor including the photocured film, and a laminated substrate and a method for manufacturing a semiconductor device using the photocurable resin composition.

### Solution to Problem

The present invention encompasses the following.
[1] A photocurable resin composition comprising a solvent and a polymer and/or compound, which contains a polycyclic aromatic hydrocarbon group.
[2] The photocurable resin composition according to [1], wherein the polycyclic aromatic hydrocarbon group is derived from at least one member selected from the group consisting of naphthalene, anthracene, phenanthrene, and pyrene.
[3] The photocurable resin composition according to [1], wherein the polymer is at least one member selected from the group consisting of polyvinyl alcohol, polyacrylamide, (meth)acrylic resin, polyamic acid, polyhydroxystyrene, polyhydroxystyrene derivative, copolymer of polymethacrylate and maleic anhydride, epoxy resin, phenol resin, novolac resin, polyimide, cellulose, cellulose derivative, starch, chitin, chitosan, gelatin, zein, sugar skeleton polymer compound, polyamide, polyethylene terephthalate, polycarbonate, polyurethane, and polysiloxane, each of which contains a polycyclic aromatic hydrocarbon group.
[4] The photocurable resin composition according to any one of [1] to [3], wherein the compound further contains a heterocyclic structure.
[5] The photocurable resin composition according to any one of [1] to [4], which is to be cured by light having a wavelength of 170 to 800 nm.
[6] The photocurable resin composition according to any one of [1] to [5], which is for forming a wafer edge protective film for manufacturing a semiconductor.
[7] The photocurable resin composition according to [6], which has a viscosity of 100 cps or less at 25°C.
[8] A photocured film of a coating film of the photocurable resin composition according to any one of [1] to [7].
[9] A wafer edge protective film for manufacturing a semiconductor, which is a photocured product of a coating film of the photocurable resin composition according to [6] or [7].
[10] The wafer edge protective film for manufacturing a semiconductor according to [9], which has a thickness of 1 nm to 10 µm.
[11] The wafer edge protective film for manufacturing a semiconductor according to [9] or [10], which is for preventing metal contamination of a wafer edge.
[12] A wafer for manufacturing a semiconductor, comprising at an end thereof the wafer edge protective film for manufacturing a semiconductor according to any one of [9] to [11].
[13] Use of the photocurable resin composition according to any one of [1] to [7] for forming a wafer edge protective film for manufacturing a semiconductor.
[14] A method for manufacturing a laminated substrate, comprising the steps of:
   applying the photocurable resin composition according to any one of [1] to [7] onto a substrate; and
   exposing the applied composition.
[15] The method for manufacturing a laminated substrate according to [14], wherein the substrate is a stepped substrate.
[16] A method for manufacturing a semiconductor device, comprising the steps of:
   applying the photocurable resin composition according to any one of [1] to [7] onto a substrate; and
   exposing the applied composition.
[17] A method for manufacturing a semiconductor device, comprising the steps of:
   (A) forming a resist film on a semiconductor substrate;
   (B) forming a resist pattern by irradiation of the resist film with a light or electron beam and subsequent development; and
   (C) processing the semiconductor substrate by etching,
   which further includes step (X) of forming a protective film of the photocurable resin composition according to [6] or [7] on a front surface edge and optionally on a bevel portion and/or back surface edge of a wafer for manufacturing a semiconductor.
[18] The method for manufacturing a semiconductor device according to [17], which includes step (X) before step (A).
[19] The method for manufacturing a semiconductor device according to [17], which includes step (X) between step (A) and step (B).
[20] The method for manufacturing a semiconductor device according to [17], which includes step (X) after either step (B) or step (C).
[21] The method for manufacturing a semiconductor device according to any one of [17] to [20], which includes, after step (X), step (Y) of removing the resist film formed on the protective film.
[22] The method for manufacturing a semiconductor device according to any one of [17] to [20], which includes, after step (X), step (Z) of removing the protective film.
[23] The method for manufacturing a semiconductor device according to [21], which includes, after step (Y), step (Z) of removing the protective film.
[24] The method for manufacturing a semiconductor device according to any one of [17] to [23], wherein the resist film contains a metal.
[25] The method for manufacturing a semiconductor device according to any one of [17] to [24], wherein step (X) includes the steps of applying the protective film-forming composition according to [4], and performing exposure and development on a predetermined region.
[26] The method for manufacturing a semiconductor device according to [22] or [23], wherein step (Z) is performed by ashing or a treatment with hydrofluoric acid, an organic solvent, an alkaline developer, or a semiconductor cleaning solution.
[27] A method for manufacturing a wafer for manufacturing a semiconductor, comprising the step of applying the protective film-forming composition according to any one of [1] to [7] to an edge of a wafer precursor, to manufacture a wafer having the protected edge.

### Advantageous Effects of Invention

According to the present invention, it is possible to provide a photocurable resin composition useful in a lithography process in manufacturing a semiconductor, particularly useful for forming a wafer edge protective film for manufacturing a semiconductor.

In addition, it is possible to provide a photocured film of the composition, particularly a wafer edge protective film for manufacturing a semiconductor, a wafer for manufacturing a semiconductor including the photocured film, and a laminated substrate and a method for manufacturing a semiconductor device using the photocurable resin composition.

### Description of Embodiments

### <Photocurable resin composition>

A photocurable resin composition according to the present invention contains a solvent and a polymer and/or compound containing a polycyclic aromatic hydrocarbon group.

In the present specification, the polycyclic aromatic hydrocarbon refers to a hydrocarbon. in which a plurality of aromatic rings are condensed. Examples thereof include indene, naphthalene, azulene, anthracene, phenanthrene, naphthacene, benz[a]anthracene, triphenylene, pyrene, and chrysene. The polycyclic aromatic hydrocarbon group refers to a functional group formed by removing at least one hydrogen atom from a polycyclic aromatic hydrocarbon. The polycyclic aromatic hydrocarbon group may have a substituent as long as the advantageous effects of the present invention are not impaired.

### [Polymer containing polycyclic aromatic hydrocarbon group]

The polymer containing a polycyclic aromatic hydrocarbon group is not particularly limited, and can be, for example, at least one member selected from the group consisting of polyvinyl alcohol, polyacrylamide, (meth)acrylic resin, polyamic acid, polyhydroxystyrene, polyhydroxystyrene derivative, copolymer of polymethacrylate and maleic anhydride, epoxy resin, phenol resin, novolac resin, polyimide, cellulose, cellulose derivative, starch, chitin, chitosan, gelatin, zein, sugar skeleton polymer compound, polyamide, polyethylene terephthalate, polycarbonate, polyurethane, and polysiloxane, each of which contains a polycyclic aromatic hydrocarbon group. These resins may be used each alone or in combination of two or more thereof.

A (meth)acrylic resin, a phenol resin, and a novolac resin are preferable.

Examples of the (meth)acrylic resin include an acrylic copolymer containing a (meth)acrylic acid ester as a main component and copolymerized with other monomers as necessary.

Examples of the (meth)acrylic acid ester include methyl (meth)acrylate, ethyl (meth)acrylate, propyl (meth)acrylate, butyl (meth)acrylate, hexyl (meth)acrylate, 2-ethylhexyl (meth)acrylate, cyclohexyl (meth)acrylate, benzyl (meth)acrylate, dimethylamino (meth)acrylate, hydroxyethyl (meth)acrylate, hydroxypropyl (meth)acrylate, and glycidyl (meth)acrylate.

Examples of the other monomers include acrylamide, methacrylamide, acrylonitrile, methacrylonitrile, styrene, α-methylstyrene, vinyl acetate, and alkyl vinyl ether.

A carboxyl group-containing acrylic resin containing a (meth)acrylic acid ester as a main component and copolymerized with an ethylenically unsaturated carboxylic acid, and as necessary, other monomers, may also be used.

As the ethylenically unsaturated carboxylic acid, acrylic acid, methacrylic acid, crotonic acid, maleic acid, fumaric acid, itaconic acid, and an acid anhydride or half ester thereof are used. Of these, acrylic acid, methacrylic acid, and maleic acid are preferable.

The acrylic copolymer has a weight average molecular weight of 1,000 to 100,000, and preferably 2,000 to 30,000, from the viewpoint of developability and adhesion. These acrylic copolymers may be combined as necessary, and may be used each alone or in combination of two or more thereof.

Examples of the novolac resin include a resin obtained by condensing a phenol compound and an aldehyde compound or a ketone compound in the presence of an acid catalyst.

Examples of the phenol compound include phenol, m-cresol, p-cresol, o-cresol, m-ethylphenol, p-ethylphenol, o-ethylphenol, 2,3,5-trimethylphenol, 2,3,5-triethylphenol, 4-tert-butylphenol, 3-tert-butylphenol, 2-tert-butylphenol, 2-tert-butyl-4-methylphenol, 2-tert-butyl-5-methylphenol, p-methoxyphenol, m-methoxyphenol, p-ethoxyphenol, m-ethoxyphenol, p-propoxyphenol, m-propoxyphenol, o-isopropenylphenol, p-isopropenylphenol, 2-methyl-4-isopropenylphenol, 2-ethyl-4-isopropenylphenol, 2,3-xylenol, 2,5-xylenol, 3,5-xylenol, 3,4-xylenol, resorcinol, hydroquinone, 4,4-dihydroxybiphenyl, phenylphenol, catechol, pyrogallol, naphthol, bisphenol C, and bisphenol A. These phenol compounds may be used each alone or in combination of two or more thereof.

Examples of the aldehyde compound include formaldehyde, paraformaldehyde, acetaldehyde, trioxane, propionaldehyde, butyraldehyde, trimethylacetaldehyde, acrolein, crotonaldehyde, cyclohexanaldehyde, furfural, furyl acrolein, benzaldehyde, terephthalaldehyde, phenylacetaldehyde, α-phenylpropylaldehyde, β-phenyl propyl aldehyde, o-hydroxybenzaldehyde, m-hydroxybenzaldehyde, p-hydroxybenzaldehyde, o-methylbenzaldehyde, m-methylbenzaldehyde, p-methylbenzaldehyde, o-chlorobenzaldehyde, m-chlorobenzaldehyde, p-chlorobenzaldehyde, and cinnamic aldehyde. These aldehyde compounds may be used each alone or in combination of two or more thereof.

Examples of the ketone compound include acetone, methyl ethyl ketone, diethyl ketone, and diphenyl ketone. These ketone compounds may be used each alone or in combination of two or more thereof.

Examples of the acid catalyst used at the time of the condensation reaction include hydrochloric acid, sulfuric acid, formic acid, oxalic acid, and p-toluenesulfonic acid.

The novolac resin has a weight average molecular weight of 1,000 to 100,000, and preferably 2,000 to 30,000, from the viewpoint of developability and adhesion. These novolac resins may be combined as necessary, and may be used each alone or in combination of two or more thereof.

Examples of the polyhydroxystyrene and the polyhydroxystyrene derivative include a homopolymer of vinylphenol and a copolymer obtained by copolymerizing vinylphenol with other compounds. Examples of the other compounds in this case include an acrylic acid derivative, acrylonitrile, a methacrylic acid derivative, methacrylonitrile, styrene, and a styrene derivative such as α-methylstyrene, p-methylstyrene, o-methylstyrene, p-methoxystyrene, or p-chlorostyrene.

The polyhydroxystyrene and the polyhydroxystyrene derivative have a weight average molecular weight of 1,000 to 100,000, and preferably 2,000 to 30,000, from the viewpoint of developability and adhesion. These polyhydroxystyrenes or polyhydroxystyrene derivatives may be used each alone or in combination of two or more thereof.

A preferred example of the polymer of the present invention is a polymer containing a polycyclic aromatic hydrocarbon group in its side chain. Examples of the (meth)acrylic resin include a (meth)acrylic resin, in which the polycyclic aromatic hydrocarbon group is bonded to a polymer backbone chain by an ester bond. Specific examples of the polymer backbone chain include benzyl methacrylate, 2-naphthyl methacrylate, and anthracene methyl methacrylate.

A polymer obtained by reacting a polycyclic aromatic hydrocarbon having a carboxy group with a polymer having an epoxy group in its side chain is preferable. Examples of the polymer having an epoxy group in its side chain include glycidyl methacrylate and epoxy cresol novolac.

### [Compound containing polycyclic aromatic hydrocarbon group]

The compound containing a polycyclic aromatic hydrocarbon group is not particularly limited, and examples thereof include a reaction product of a polycyclic aromatic hydrocarbon compound containing a functional group having reactivity with an epoxy group, and a compound represented by the following Formula (1): 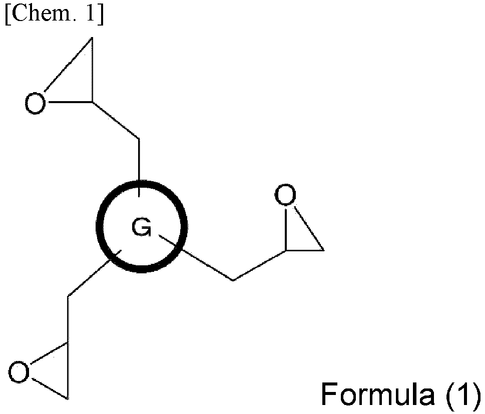 (in Formula (1), G represents an organic group containing an aliphatic ring, an aromatic ring, or a heterocyclic ring).

Examples of the functional group having reactivity with an epoxy group include a hydroxy group, an acyl group, an acetyl group, a formyl group, a benzoyl group, a carboxy group, a carbonyl group, an amino group, an imino group, a cyano group, an azo group, an azide group, a thiol group, a sulfo group, an allyl group, and an acid anhydride, and a carboxy group is preferable.

The lower limit of the weight average molecular weight of the reaction product (a) is, for example, 500, 1,000, 2,000, or 3,000, and the upper limit of the weight average molecular weight of the reaction product is, for example, 30,000, 20,000, or 10,000.

Examples of the compound represented by Formula (1) are as follows:

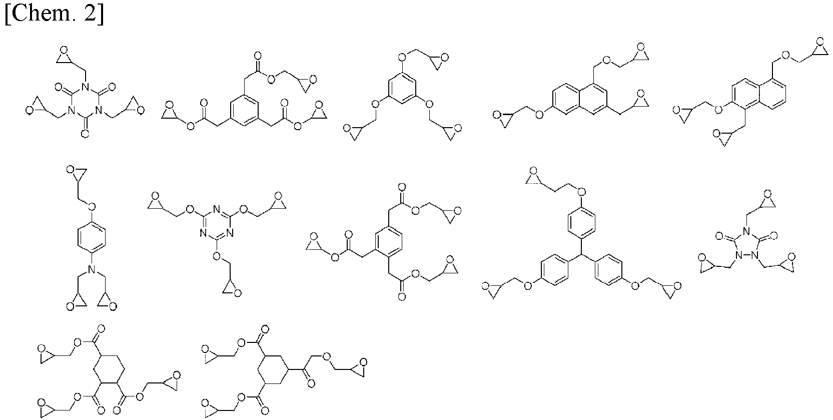

G in Formula (1) is preferably a heterocyclic ring. The heterocyclic ring is preferably a triazine. The heterocyclic ring is preferably 1,2,3-triazine. The heterocyclic ring is preferably triazinetrione.

The polycyclic aromatic hydrocarbon compound containing a functional group having reactivity with an epoxy group may be a compound represented by the following Formula (1-1) disclosed in WO 2020/071361 A.

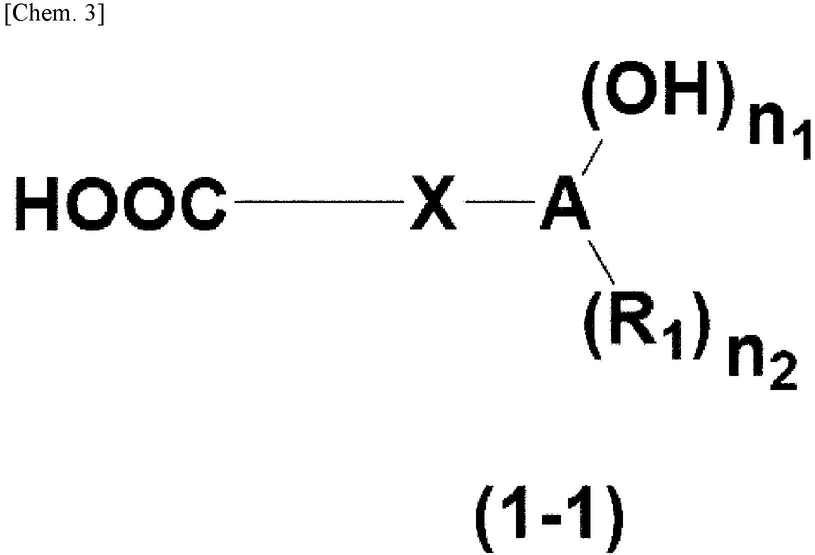

(In Formula (1-1), X is a divalent organic group, A is a polycyclic aromatic hydrocarbon group, R₁ is a halogen atom, an optionally substituted alkyl group having 1 to 40 carbon atoms, or an optionally substituted alkoxy group having 1 to 40 carbon atoms, n1 is an integer of 1 to 12, and n2 is an integer of 0 to 11.)

The carboxy group in Formula (1-1) may be substituted with a hydroxy group, an acyl group, an acetyl group, a formyl group, a benzoyl group, a carboxy group, a carbonyl group, an amino group, an imino group, a cyano group, an azo group, an azide group, a thiol group, a sulfo group, or an allyl group.

In addition, the polycyclic aromatic hydrocarbon compound containing a functional group having reactivity with an epoxy group may be a compound represented by the following Formula (2-1) disclosed in WO 2020/071361 A.

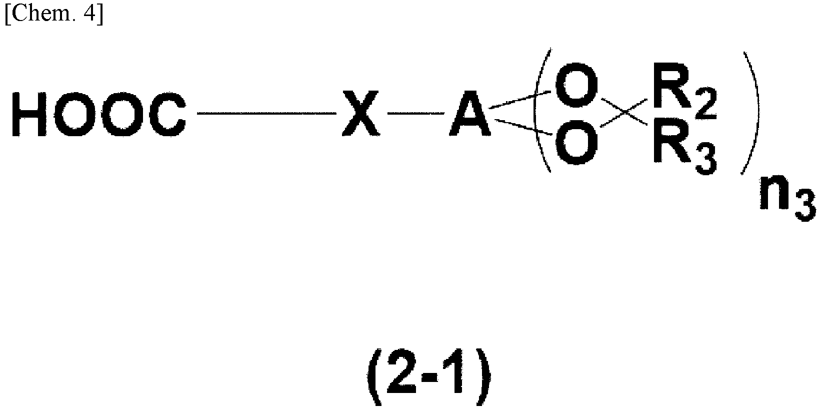

(In Formula (2-1), X is a divalent organic group, A is polycyclic aromatic hydrocarbon group, R₂ and R₃ are each independently a hydrogen atom, an optionally substituted alkyl group having 1 to 10 carbon atoms, an optionally substituted aryl group having 6 to 40 carbon atoms, or a halogen atom, and n3 is an integer of 1 to 12.)

The carboxy group in Formula (2-1) may be substituted with a hydroxy group, an acyl group, an acetyl group, a formyl group, a benzoyl group, a carboxy group, a carbonyl group, an amino group, an imino group, a cyano group, an azo group, an azide group, a thiol group, a sulfo group, or an allyl group.

Specific examples of X include an ester bond, an ether bond, an amide bond, a urethane bond, and a urea bond.

Specific examples of A include groups derived from naphthalene, anthracene, phenanthrene, or pyrene.

Examples of the halogen atom include a fluorine atom, a chlorine atom, a bromine atom, and an iodine atom.

Specific examples of the alkyl group include a methyl group, an ethyl group, a propyl group, a butyl group, a hexyl group, and a pentyl group.

Specific examples of the alkoxy group include a methoxy group, an ethoxy group, a propoxy group, a butoxy group, a hexoxy group, and a pentoxy group.

Examples of the aryl group include a phenyl group and a naphthyl group.

The phrase "optionally substituted" means that some or all hydrogen atoms of the alkyl or alkoxy group may be substituted with, for example, a fluoro group or a hydroxy group.

The entire disclosure of WO 2020/071361 A is incorporated into the present application by reference.

### [Solvent]

Examples of the solvent contained in the photocurable resin composition according to the present invention include water, ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monoethyl ether, propylene glycol monomethyl ether acetate, propylene glycol propyl ether acetate, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide. These solvents may be used each alone or in combination of two or more thereof.

Of these solvents, propylene glycol monomethyl ether, propylene glycol monomethyl ether acetate, ethyl lactate, butyl lactate, and cyclohexanone are preferable. In particular, propylene glycol monomethyl ether and propylene glycol monomethyl ether acetate are preferable.

The solvent may be added so that the photocurable resin composition according to the present invention has an appropriate viscosity. In general, it is preferable that the proportion is about 100 to 3,000 parts by mass of the solvent with respect to 100 parts by mass of the polymer or compound, which contains a polycyclic aromatic hydrocarbon group.

The polymer and/or compound containing a polycyclic aromatic hydrocarbon group according to the present invention can cause photocuring due to the polycyclic aromatic hydrocarbon group, even without having a crosslinkable group (for example, an epoxy group, an acrylic group, a vinyl group, a carboxylic acid group, a thiol group, a silanol group, a cinnamoyl group, a hydroxyl group (including a phenolic hydroxyl group), or the like) capable of forming a crosslinked structure by an action of light, an electron beam, other electromagnetic waves, a radical, an acid, heat, water, oxygen, or the like.

In addition, the photocurable resin composition according to the present invention can cause photocuring without blending any special additives, and may contain, as necessary, a radical polymerization initiator (a photopolymerization initiator or the like), an acid (a catalyst), a thermal acid generator, a photoacid generator, a base (a catalyst), a thermal base generator, a photobase generator, an antioxidant, a polymerization inhibitor, a crosslinking agent (polyfunctional acrylic or the like), an adhesion improver, an adhesion aid (a silane coupling agent), a surfactant, an antifoaming agent, a rheology modifier, a pigment, a dye, a storage stabilizer, a dissolution accelerator such as a polyhydric phenol or a polyhydric carboxylic acid, a sensitizer, and the like.

The radical polymerization initiator may be any initiator as long as it can release a substance that initiates radical polymerization by light irradiation and/or heating. Examples of a photoradical polymerization initiator include a benzophenone derivative, an imidazole derivative, a bisimidazole derivative, an N-arylglycine derivative, an organic azide compound, a titanocene compound, an aluminate complex, an organic peroxide, an N-alkylpyridinium salt, and a thioxanthone derivative. More specifically, examples thereof include, but are not limited to, benzophenone, 1,3-di(tert-butyldioxycarbonyl)benzophenone, 3,3',4,4'-tetrakis(tert-butyldioxycarbonyl)benzophenone, 3-phenyl-5-isoxazolone, 2-mercaptobenzimidazole, bis(2,4,5-triphenyl)imidazole, 2,2-dimethoxy-1,2-diphenylethan-1-one, 1-hydroxycyclohexylphenyl ketone, 2-benzyl-2-dimethylamino-1-(4-morpholinophenyl)-butan-1-one, and bis(η⁵-2,4-cyclopentadien-1-yl)-bis(2,6-difluoro-3-(1H-pyrrol-1-yl)-phenyl)titanium).

As the photoradical polymerization initiator, a commercially available product may also be used, and examples thereof include IRGACURE (registered trademark) 651, 184, 369, and 784 manufactured by BASF SE. In addition, specific examples of the commercially available product include IRGACURE (registered trademark) 500, 907, 379, 819, 127, 500, 754, 250, 1800, 1870, and OXE01, and DAROCUR (registered trademark) TPO and 1173 manufactured by BASF SE; Speedcure (registered trademark) MBB, PBZ, ITX, CTX, and EDB manufactured by Lambson Ltd.; Esacure (registered trademark) ONE, KIP150, and KTO46 manufactured by Lamberti S.p.A.; and KAYACURE (registered trademark) DETX-S, CTX, BMS, and DMBI manufactured by Nippon Kayaku Co., Ltd.

In addition, examples of a thermal radical polymerization initiator include, but are not limited to, a peroxide such as acetyl peroxide, benzoyl peroxide, methyl ethyl ketone peroxide, cyclohexanone peroxide, hydrogen peroxide, tert-butyl hydroperoxide, cumene hydroperoxide, di-tert-butyl peroxide, dicumyl peroxide, dilauroyl peroxide, tert-butyl peroxy acetate, tert-butyl peroxy pivalate, or tert-butyl peroxy-2-ethylhexanoate; an azo compound such as 2,2'-azobisisobutyronitrile, 2,2'-azobis(2,4-dimethylvaleronitrile), (1-phenylethyl)azodiphenylmethane, 2,2'-azobis(4-methoxy-2,4-dimethylvaleronitrile), dimethyl-2,2'-azobisisobutyrate, 2,2'-azobis(2-methylbutyronitrile), 1,1'-azobis(1-cyclohexanecarbonitrile), 2-(carbamoylazo)isobutyronitrile, 2,2'-azobis(2,4,4-trimethylpentane), 2-phenylazo-2,4-dimethyl-4-methoxyvaleronitrile, or 2,2'-azobis(2-methylpropane); and a persulfate such as ammonium persulfate, sodium persulfate, or potassium persulfate.

Examples of the commercially available thermal radical polymerization initiator include, but are not limited to, PERLOYL (registered trademark) IB, NPP, IPP, SBP, TCP, OPP, SA, 355, and L, PERBUTYL (registered trademark) ND, NHP, MA, PV, 355, A, C, D, E, L, I, O, P, and Z, PERHEXYL (registered trademark) ND, PV, D, I, O, and Z, PEROCTA (registered trademark) ND, NYPER (registered trademark) PMB, BMT, and BW, PERTETRA (registered trademark) A, PERHEXA (registered trademark) MC, TMH, HC, 250, 25B, C, 25Z, 22, and V, PEROCTA (registered trademark) O, PERCUMYI, (registered trademark) ND and D, PERMENTA (registered trademark) H, and NOFMER (registered trademark) BC manufactured by NOF CORPORATION; V-70, V-65, V-59, V-40, V-30, VA-044, VA-046B, VA-061, V-50, VA-057, VA-086, VF-096, VAm-110, V-601, and V-501 manufactured by Wako Pure Chemical Industries, Ltd.; IRGACURE (registered trademark) 184, 369, 651, 500, 819, 907, 784, 2959, CGI1700, CGI1750, CGI1850, and CG24-61, DAROCUR (registered trademark) 1116 and 1173, and LUCIRIN (registered trademark) TPO manufactured by BASF SE; UVECRYI, (registered trademark) P36 manufactured by Cytec Surface Specialties S.A.; and Esacure (registered trademark) KIP150, KIP65LT, KIP100F, KT37, KT55, KTO46, and KIP75B manufactured by Lamberti S.p.A.

The radical polymerization initiators may be used each alone or in combination of two or more thereof. The content of the radical polymerization initiator is preferably 1 part by mass or more, 2 parts by mass or more, 3 parts by mass or more, 50 parts by mass or less, 20 parts by mass or less, or 10 parts by mass or less, with respect to 100 parts by mass of the polymer and/or compound, which contains a ring aromatic hydrocarbon group.

As the catalyst, an acidic compound, a basic compound, or various compounds that generate an acid or base by heat may be used.

As the acidic compound, a sulfonic acid compound or a carboxylic acid compound may be used.

Examples of the sulfonic acid compound or carboxylic acid compound include p-toluenesulfonic acid, trifluoromethanesulfonic acid, pyridinium trifluoromethanesulfonate (=pyridinium trifluoromethanesulfonic acid), pyridinium-p-toluenesulfonate, pyridinium-4-hydroxybenzene sulfonate, salicylic acid, camphorsulfonic acid, 5-sulfosalicylic acid, 4-chlorobenzenesulfonic acid, 4-phenolsulfonic acid, pyridinium-4-phenolsulfonate, benzenedisulfonic acid, 1-naphthalenesulfonic acid, 4-nitrobenzenesulfonic acid, citric acid, benzoic acid, and hydroxybenzoic acid.

As the basic compound, an amine compound or an ammonium hydroxide compound may be used, and as the compound that generates a base by heat, urea may be used.

Examples of the amine compound include tertiary amines such as triethanolamine, tributanolamine, trimethylamine, triethylamine, tri-n-propylamine, triisopropylamine, tri-n-butylamine, tri-tert-butylamine, tri-n-octylamine, triisopropanolamine, phenyldiethanolamine, stearyldiethanolamine, and diazabicyclooctane, and aromatic amines such as pyridine and 4-dimethylaminopyridine. In addition, examples of the amine compound include primary amines such as benzylamine and n-butylamine, and secondary amines such as diethylamine and di-n-butylamine.

Examples of the ammonium hydroxide compound include tetramethylammonium hydroxide, tetraethylammonium hydroxide, tetrapropylammonium hydroxide, tetrabutylammonium hydroxide, benzyltrimethylammonium hydroxide, benzyltriethylammonium hydroxide, cetyltrimethylammonium hydroxide, phenyltrimethylammonium hydroxide, and phenyltriethylammonium hydroxide.

As the acid generator, both a thermal acid generator and photoacid generator may be used.

Examples of the thermal acid generator include sulfonic acid compounds and carboxylic acid compounds, such as p-toluenesulfonic acid, trifluoromethanesulfonic acid, pyridinium p-toluenesulfonate (pyridinium p-toluenesulfonic acid), pyridinium p-hydroxybenzenesulfonic acid (p-phenolsulfonic acid pyridinium salt), pyridiniumtrifluoromethanesulfonic acid, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, and hydroxybenzoic acid.

Examples of the commercially available product include K-PURE [registered trademark] CXC-1612, K-PURE CXC-1614, K-PURE TAG-2172, K-PURE TAG-2179, K-PURE TAG-2678, and K-PURE TAG2689 (manufactured by King Industries, Inc.) and SI-45, SI-60, SI-80, SI-100, SI-110, and SI-150 (manufactured by SANSHIN CHEMICAL INDUSTRY CO., LTD.).

Examples of the photoacid generator include a sulfonium salt, an iodonium salt, sulfonyl diazomethane, N-sulfonyloxyimide, a benzoinsulfonate photoacid generator, a pyrogallol trisulfonate photoacid generator, a sulfone photoacid generator, a glyoxime derivative photoacid generator, an oxime-O-sulfonate acid generator, and a bisoxime sulfonate acid generator. Examples thereof include bis(4-tert-butylphenyl)iodonium trifluoromethanesulfonate, triphenylsulfonium trifluoromethanesulfonate, phenyl-bis(trichloromethyl)-s-triazine, benzoin tosylate, and N-hydroxysuccinimide trifluoromethanesulfonate.

These acid generators may be used each alone or in combination of two or more thereof. The content of the photoacid generator is preferably within the range of 1 to 100 parts by weight with respect to 100 parts by weight of the polymer and/or compound, which contains a ring aromatic hydrocarbon group.

Examples of the thermal base generator include carbamates such as 1-methyl-1-(4-biphenylyl)ethyl carbamate and 2-cyano-1,1-dimethylethyl carbamate; ureas such as urea and N,N-dimethyl-N'-methylurea; guanidines such as guanidine trichloroacetate, guanidine phenyl sulfonyl acetate, and guanidine phenylpropiolate; dihydropyridines such as 1,4-dihydronicotinamide; dimethylpiperidines such as N-(isopropoxycarbonyl)-2,6-dimethylpiperidine, N-(tert-butoxycarbonyl)-2,6-dimethylpiperidine, and N-(benzyloxycarbonyl)-2,6-dimethylpiperidine; quaternized ammonium salts such as tetramethylammonium phenyl sulfonyl acetate and tetramethylammonium phenylpropiolate; and dicyandiamide. In addition, examples thereof include U-CAT (registered trademark) SA810, SA831, SA841, and SA851 [manufactured by San-Apro Ltd.], which are salts of 1,8-diazabicyclo[5.4.0]undec-7-ene (DBU).

Examples of the photobase generator include an alkylamine-based photobase generator such as 9-anthrylmethyl=N,N-diethyl carbamate; a cycloalkylamine-based photobase generator such as 9-anthryl=N,N-dicyclohexyl carbamate, 1-(9,10-anthraquinone-2-yl)ethyl=N,N-dicyclohexyl carbamate, dicyclohexylammonium=2-(3-benzoylphenyl)propionate, 9-anthryl=N-cyclohexylcarbamate, 1-(9,10-anthraquinone-2-yl)ethyl=N-cyclohexyl carbamate, cyclohexylammonium=2-(3-benzoylphenyl) propionate, or (E)-N-cyclohexyl-3-(2-hydroxyphenyl)acrylamide; a piperidine-based photobase generator such as 9-anthrylmethyl=piperidine-1-carboxylate, (E)-1-piperidino-3-(2-hydroxyphenyl)-2-propen-1-one, or (2-nitrophenyl)methyl=4-hydroxypiperidine-1-carboxylate, (2-nitrophenyl)methyl=4-(methacryloyloxy)piperidine-1-carboxylate; a guanidine-based photobase generator such as guanidinium=2-(3-benzoylphenyl)propionate, 1,2-diisopropyl-3-(bis(dimethylamino)methylene)guanidinium=2-(3-benzoylphenyl)propionate, 1,2-dicyclohexyl-4,4,5,5-tetramethylbiguanidium=n-butyltriphenylborate, or 1,5,7-triazabicyclo[4.4.0]dec-5-enium=2-(9-oxoxanthene-2-yl)propionate; and an imidazolebased photobase generator such as 1-(9,10-anthraquinone-2-yl)ethyl=imidazole-1-carboxylate.

Similarly to the photoacid generator, these photobase generators may be used each alone or in combination of two or more thereof. In addition, the content thereof is preferably within the range of 1 to 100 parts by weight with respect to 100 parts by weight of the polymer and/or compound, which contains a ring aromatic hydrocarbon group.

As the polymerization inhibitor, a hindered phenol compound may be used, and specific examples thereof include 2,6-diisobutylphenol, 3,5-di-t-butylphenol, 3,5-di-t-butylcresol, hydroquinone, hydroquinone monomethyl ether, N-nitroso-N-phenylhydroxylamine aluminum, pyrogallol, t-butylcatechol, 4-methoxy-1-naphthol, 2,6-di-t-butyl-4-methylphenol, 2,5-di-t-butyl-hydroquinone, octadecyl-3-(3,5-di-t-butyl-4-hydroxyphenyl)propionate, isooctyl-3-(3,5-di-t-butyl)-4-hydroxyphenyl)propionate, 4,4'-methylenebis(2,6-di-t-butylphenol), 4,4'-thio-bis(3-methyl-6-t-butylphenol), 4,4'-butylidene-bis(3-methyl-6-t-butylphenol), triethylene glycol-bis[3-(3-t-butyl-5-methyl-4-hydroxyphenyl)propionate], 1,6-hexanediol-bis[3-(3,5-di-t-butyl-4)-hydroxyphenyl)propionate], 2,2-thio-diethylenebis[3-(3,5-di-t-butyl-4-hydroxyphenyl)propionate], N,N'-hexamethylenebis(3,5-di-t-butyl-4-hydroxyhydrocinnamamide), 2,2'-methylene-bis(4-methyl-6-t-butylphenol), 2,2'-methylenebis(4-ethyl-6-t-butylphenol), pentaerythrityl-tetrakis[3-(3,5-di-t-butyl-4-hydroxyphenyl)propionate], tris-(3,5-di-t-butyl-4-hydroxybenzyl)-isocyanurate, 1,3,5-trimethyl-2,4,6-tris(3,5-di-t-butyl-4 -hydroxybenzyl)benzene, 1,3,5-tris(3-hydroxy-2,6-dimethyl-4-isopropylbenzyl)-1,3,5-triazine-2,4,6-(1H,3H,SH)-trione, 1,3,5-tris(4-t-butyl-3-hydroxy-2,6-dimethylbenzyl)-1,3,5-triazine-2,4,6-(1H,3H,5H)-trione, 1,3,5-tris(4-s-butyl-3-hydroxy-2,6-dimethylbenzyl)-1,3,5-triazine-2,4,6-(1H,3H,5H)-trione, 1,3,5-tris[4-(1-ethylpropyl)-3-hydroxy-2,6-dimethylbenzyl]-1,3,5-triazine-2,4,6-(1H,3H,5H)-trione, 1,3,5-tris[4-triethylmethyl-3-hydroxy-2,6-dimethylbenzyl]-1,3,5-triazine-2,4,6-(1H,3H,SH)-trione, 1,3,5-tris(3-hydroxy-2,6-dimethyl-4-phenylbenzyl)-1,3,5-triazine-2,4,6-(1H,3H,5H)-trione, 1,3,5-tris(4-t-butyl-3-hydroxy-2,5,6-trimethylbenzyl)-1,3,5-triazine-2,4,6-(1H,3H,SH)-trione, 1,3,5-tris(4-t-butyl-5-ethyl-3-hydroxy-2,6-dimethylbenzyl)-1,3,5-triazine-2,4,6-(1H,3H,5H)-trione, 1,3,5-tris(4-t-butyl-6-ethyl-3-hydroxy-2-methylbenzyl)-1,3,5-triazine-2,4,6-(1H,3H,5H)-trione, 1,3,5-tris(4-t-butyl-6-ethyl-3-hydroxy-2,5-dimethylbenzyl)-1,3,5-triazine-2,4,6-(1H,3H,5H)-trione, 1,3,5-tris(4-t-butyl-5,6-diethyl-3-hydroxy-2-methylbenzyl)-1,3,5-triazine-2,4,6-(1H,3H,5H)-trione, 1,3,5-tris(4-t-butyl-3-hydroxy-2-methylbenzyl)-1,3,5-triazine-2,4,6-(1H,3H,5H)-trione, 1,3,5-tris(4-t-butyl-3-hydroxy-2,5-dimethylbenzyl)-1,3,5-triazine-2,4,6-(1H,3H,SH)-trione, and 1,3,5-tris(4-t-butyl-5-ethyl-3-hydroxy-2-methylbenzyl)-1,3,5-triazine-2,4,6-(1H,3H,5H)-trione.

Of the hindered phenol compounds, 1,3,5-tris(4-t-butyl-3-hydroxy-2,6-dimethylbenzyl)-1,3,5-triazine-2,4,6-(1H,3H,SH)-trione is preferable.

As the polymerization inhibitor, a commercially available product may be used, and specific examples thereof include Irganox-3114 (manufactured by BASF Japan Ltd.).

The polymerization inhibitors may be used each alone or in combination of two or more thereof. The content of the polymerization inhibitor is preferably within the range of 0.01 to 1 part by mass, and more preferably 0.01 to 0.5 parts by mass, with respect to 100 parts by weight of the polymer and/or compound, which contains a ring aromatic hydrocarbon group.

Examples of the surfactant include a polyoxyethylene alkyl ether compound such as polyoxyethylene lauryl ether, polyoxyethylene stearyl ether, or polyoxyethylene oleyl ether, a polyoxyethylene alkyl allyl ether compound such as polyoxyethylene octyl phenol ether or polyoxyethylene nonyl phenol ether, a polyoxyethylenepolyoxypropylene block copolymer compound, a sorbitan fatty acid ester compound such as sorbitan monolaurate, sorbitan monopalmitate, sorbitan monostearate, sorbitan trioleate, or sorbitan tristearate, and a polyoxyethylene sorbitan fatty acid ester compound such as polyoxyethylene sorbitan monolaurate, polyoxyethylene sorbitan monopalmitate, polyoxyethylene sorbitan monostearate, or polyoxyethylene sorbitan tristearate. In addition, examples thereof include fluorine-based surfactants such as EFTOP EF301, EF303, and EF352 (trade name) (manufactured by Tochem Products Inc.), MEGAFACE F171, F173, R-08, and R-30 (trade name) (manufactured by DIC Corporation), FLUORAD FC430 and FC431 (manufactured by Sumitomo 3M Ltd.), and AsahiGuard AG710 and SURFLON S-382, SC101, SC102, SC103, SC104, SC105, and SC106 (trade name) (manufactured by AGC Inc.) and Organosiloxane Polymer-KP341 (manufactured by Shin-Etsu Chemical Co., Ltd.).

The surfactants may be used each alone or in combination of two or more thereof. The content of the surfactant is preferably 0.1 parts by mass or more, 0.5 parts by mass or more, 5 parts by mass or less, or 2 parts by mass or less, with respect to 100 parts by weight of the polymer and/or compound, which contains a ring aromatic hydrocarbon group.

In addition, in order to improve adhesion to the substrate after development, the photocurable resin composition may contain an adhesion accelerator. Specific examples of the adhesion accelerator include chlorosilanes such as trimethylchlorosilane, dimethylvinylchlorosilane, methyldiphenylchlorosilane, and chloromethyldimethylchlorosilane; alkoxysilanes such as trimethylmethoxysilane, dimethyldiethoxysilane, methyldimethoxysilane, dimethylvinylethoxysilane, diphenyldimethoxysilane, and phenyltriethoxysilane; silazanes such as hexamethyldisilazane, N,N'-bis(trimethylsilyl)urea, dimethyltrimethylsilylamine, and trimethylsilylimidazole; silanes such as vinyltrichlorosilane, γ-chloropropyltrimethoxysilane, γ-aminopropyltriethoxysilane, γ-methacryloxypropyltrimethoxysilane, and γ-glycidoxypropyltrimethoxysilane; heterocyclic compounds such as benzotriazole, benzimidazole, indazole, imidazole, 2-mercaptobenzimidazole, 2-mercaptobenzothiazole, 2-mercaptobenzoxazole, urazole, thiouracil, mercaptoimidazole, and mercaptopyrimidine; and urea such as 1,1-dimethyleneurea or 1,3-dimethyl urea or thiourea compounds.

The blending amount of the adhesion accelerator is usually 20 parts by weight or less, preferably within the range of 0.05 to 10 parts by weight, and particularly preferably 1 to 10 parts by weight, with respect to 100 parts by weight of the polymer and/or compound, which contains a ring aromatic hydrocarbon group.

Examples of the dye include an acidic dye, an oil-soluble dye, a disperse dye, a reactive dye, and a direct dye. Examples of the dye include an azo dye, a benzoquinone dye, a naphthoquinone, an anthraquinone dye, a cyanine dye, a squarylium dye, a croconium dye, a merocyanine dye, a stilbene dye, a diphenylmethane dye, a triphenylmethane dye, a fluoran dye, a spiropyran dye, a phthalocyanine dye, an indigo dye, a fulgide dye, a nickel complex dye, and an azulene dye. Specific examples thereof include the following color index numbers: C. I. Solvent Yellow 2, 3, 7, 12, 13, 14, 16, 18, 19, 21, 25, 25:1, 27, 28, 29, 30, 33, 34, 36, 42, 43, 44, 47, 56, 62, 72, 73, 77, 79, 81, 82, 83, 83:1, 88, 89, 90, 93, 94, 96, 98, 104, 107, 114, 116, 117, 124, 130, 131, 133, 135, 141, 143, 145, 146, 157, 160:1, 161, 162, 163, 167, 169, 172, 174, 175, 176, 179, 180, 181, 182, 183, 184, 185, 186, 187, 189, 190, and 191, C. I. Solvent Orange 1, 2, 3, 4, 5, 7, 11, 14, 20, 23, 25, 31, 40:1, 41, 45, 54, 56, 58, 60, 62, 63, 70, 75, 77, 80, 81, 86, 99, 102, 103, 105, 106, 107, 108, 109, 110, 111, 112, and 113, C. I. Solvent Red 1, 2, 3, 4, 8, 16, 17, 18, 19, 23, 24, 25, 26, 27, 30, 33, 35, 41, 43, 45, 48, 49, 52, 68, 69, 72, 73, 83:1, 84:1, 89, 90, 90:1, 91, 92, 106, 109, 110, 118, 119, 122, 124, 125, 127, 130, 132, 135, 141, 143, 145, 146, 149, 150, 151, 155, 160, 161, 164, 164:1, 165, 166, 168, 169, 172, 175, 179, 180, 181, 182, 195, 196, 197, 198, 207, 208, 210, 212, 214, 215, 218, 222, 223, 225, 227, 229, 230, 233, 234, 235, 236, 238, 239, 240, 241, 242, 243, 244, 245, 247, and 248, C. I. Solvent Violet 2, 8, 9, 11, 13, 14, 21, 21:1, 26, 31, 36, 37, 38, 45, 46, 47, 48, 49, 50, 51, 55, 56, 57, 58, 59, 60, and 61, C. I. Solvent Blue 2, 3, 4, 5, 7, 18, 25, 26, 35, 36, 37, 38, 43, 44, 45, 48, 51, 58, 59, 59:1, 63, 64, 67, 68, 69, 70, 78, 79, 83, 94, 97, 98, 100, 101, 102, 104, 105, 111, 112, 122, 124, 128, 129, 132, 136, 137, 138, 139, and 143, C. I. Solvent Green 1, 3, 4, 5, 7, 28, 29, 32, 33, 34, and 35, C. I. Solvent Brown 1, 3, 4, 5, 12, 20, 22, 28, 38, 41, 42, 43, 44, 52, 53, 59, 60, 61, 62, and 63, C. I. Solvent Black 3, 5, 5:2, 7, 13, 22, 22:1, 26, 27, 28, 29, 34, 35, 43, 45, 46, 48, 49, and 50, C. I. Acid Red 6, 11, 26, 60, 88, 111, 186, and 215, C. I. Acid Green 25 and 27, C. I. Acid Blue 22, 25, 40, 78, 92, 113, 129, 167, and 230, C. I. Acid Yellow 17, 23, 25, 36, 38, 42, 44, 72, and 78, C. I. Basic Red 1, 2, 13, 14, 22, 27, 29, and 39, C. I. Basic Green 3 and 4, C. I. Basic Blue 3, 9, 41, and 66, C. I. Basic Violet 1, 3, 18, 39, and 66, C. I. Basic Yellow 11, 23, 25, 28, and 41, C. I. Direct Red 4, 23, 31, 75, 76, 79, 80, 81, 83, 84, 149, and 224, C. I. Direct Green 26 and 28, C. I. Direct Blue 71, 78, 98, 106, 108, 192, and 201, C. I. Direct Violet 51, C. I. Direct Yellow 26, 27, 28, 33, 44, 50, 86, and 142, C. I. Direct Orange 26, 29, 34, 37, and 72, C. I. Sulphur Red 5, 6, and 7, C. I. Sulphur Green 2, 3, and 6, C. I. Sulphur Blue 2, 3, 7, 9, 13, and 15, C. I. Sulphur Violet 2, 3, and 4, C. I. Sulphur Yellow 4, C. I. Vat Red 13, 21, 23, 28, 29, and 48, C. I. Vat Green 3, 5, and 8, C. I. Vat Blue 6, 14, 26, and 30, C. I. Vat Violet 1, 3, 9, 13, 15, and 16, C. I. Vat Yellow 2, 12, 20, and 33, C. I. Vat Orange 2, 5, 11, 15, 18, and 20, C. I. Azoic Coupling Component 2, 3, 4, 5, 7, 8, 9, 10, 11, 13, 32, 37, 41, and 48, C. I. Reactive Red 8, 22, 46, and 120, C. I. Reactive Blue 1, 2, 7, and 19, C. I. Reactive Violet 2 and 4, C. I. Reactive Yellow 1, 2, 4, 14, and 16, C. I. Reactive Orange 1, 4, 7, 13, 16, and 20, C. I. Disperse Red 4, 11, 54, 55, 58, 65, 73, 127, 129, 141, 196, 210, 229, 354, and 356, C. I. Disperse Blue 3, 24, 79, 82, 87, 106, 125, 165, and 183, C. I. Disperse Violet 1, 6, 12, 26, 27, and 28, C. I. Disperse Yellow 3, 4, 5, 7, 23, 33, 42, 60, and 64, and C. I. Disperse Orange 13, 29, and 30. These dyes may be used each alone or in combination of two or more thereof in order to express a desired spectral spectrum.

The blending amount of the dye is usually selected within the range of 1 to 90% by mass with respect to the entire solid content (100%) of the photocurable resin composition according to the present invention.

A compatibilizer that suppresses precipitation of a dye may be added to the photocurable resin composition of the present application.

Examples of the compatibilizer that suppresses precipitation of a dye include an alkyl ether compound such as a polyoxyethylene octyl ether compound, a polyoxyethylene lauryl ether compound, a polyoxyethylene alkyl (12 or 13 carbon atoms) ether compound, a polyoxyethylene secondary alkyl (12 to 14 carbon atoms) ether compound, a polyoxyethylene alkyl (13 carbon atoms) ether compound, a polyoxyethylene cetyl ether compound, a polyoxyethylene stearyl ether compound, a polyoxyethylene oleyl ether compound, a polyoxyethylene decyl ether compound, a polyoxyalkylene alkyl (11 to 15 carbon atoms) ether compound, a polyoxyalkylene secondary alkyl (12 to 14 carbon atoms) ether compound, or a polyoxyalkylene cetyl ether compound, an alkylamino ether compound such as a polyoxyethylene lauryl amino ether compound, a polyoxyethylene stearyl amino ether compound, or a polyoxyethylene oleyl amino ether compound, an alkylamide ether compound such as a polyoxyethylene lauric acid amide ether compound, a polyoxyethylene stearic acid amide ether compound, a polyoxyethylene oleic acid amide ether compound, a lauric acid diethanolamide compound, a stearic acid diethanolamide compound, or an oleic acid diethanolamide compound, an allyl phenyl ether compound such as a polyoxyethylene polystylphenyl ether compound, a polyoxyalkylene polystylphenyl ether compound, a polyoxyalkylene polystylphenyl ether formamide condensate, a polyoxyethylene monostyrylphenyl ether compound, a polyoxyethylene distyrylphenyl ether compound, or a polyoxyethylene naphthyl ether compound, a glycerin fatty acid ester compound such as a glycerin monolaurate compound, a glycerin monostearate compound, a glycerin monooleate compound, or a glycerin trioleate compound, a sorbitan acid ester compound such as a sorbitan monolaurate compound, a sorbitan monopalmitate compound, a sorbitan monostearate compound, a sorbitan tristearate compound, a sorbitan monooleate compound, or a sorbitan trioleate compound, a fatty acid ether ester compound such as a polyoxyethylene dilaurate compound, a polyoxyethylene laurate compound, a polyoxyethylene stearate compound, a polyoxyethylene distearate compound, a polyoxyethylene dioleate compound, or a polyoxyethylene oleate compound, a vegetable oil ether ester compound such as a polyoxyethylene castor oil ether compound or a polyoxyethylene hydrogenated castor oil ether compound, a sorbitan ether ester compound such as a polyoxyethylene sorbitan monolaurate compound, a polyoxyethylene sorbitan monostearate compound, a polyoxyethylene sorbitan monooleate compound, or a polyoxyethylene sorbitan trioleate compound, a monool type polyether compound such as a polyoxyalkylene butyl ether compound, a polyoxyalkylene octyl ether compound, a polyoxyalkylene alkyl (14 or 15 carbon atoms) ether compound, or a polyoxyalkylene oleyl ether compound, a diol-type polyether compound such as a polyoxyethylene polyoxypropylene condensate, a polyol-type polyether compound such as a trimethylolpropane tris(polyoxyalkylene) ether compound or a polyoxyalkylene glyceryl ether compound, a fatty acid alkyl ester compound such as a methyl laurate compound, a methyl oleate compound, an isopropyl myristate compound, a butyl stearate compound, an octyl palmitate compound, an octyl stearate compound, a lauryl oleate compound, an isotridecyl stearate compound, an oleyl oleate compound, a dioleyl adipate compound, a trimethylolpropane tridecanoate compound, a trimethylolpropane trilaurate compound, a pentaerythritol dioleate compound, a pentaerythritol monostearate compound, or a pentaerythritol distearate compound, a sulfonic acid type compound such as an alkyl sulfonate compound, a long chain alkylbenzene sulfonate compound, a branched alkylbenzene sulfonate compound, a long chain alkylbenzene sulfonate compound, a branched alkylbenzene sulfonate compound, a branched alkyl diphenyl ether disulfonate compound, a monoisopropyl naphthalene sulfonate compound, a diisopropylnaphthalene sulfonate compound, a triisopropylnaphthalene sulfonate compound, a dibutylnaphthalene sulfonate compound, or a dioctyl sulfosuccinate compound, a sulfate ester compound such as an oleic acid sulfated oil compound, a castor sulfated compound, an octyl sulfate compound, a lauryl sulfate compound, an alkyl sulfate compound, or an alkyl ether sulfate compound, cellulose, a cellulose derivative, and a sugar skeleton polymer compound.

The proportion of the compatibilizer used is usually within the range of 0.001 to 20 parts by weight with respect to 100 parts by weight of the polymer and/or compound, which contains a ring aromatic hydrocarbon group. However, when the compatibilizer does not inhibit the pattern shape, 20 parts by weight or more of the compatibilizer may be used.

Examples of the crosslinking agent include hexamethoxymethylmelamine, tetramethoxymethyl benzoguanamine, 1,3,4,6-tetrakis(methoxymethyl)glycoluril (tetramethoxymethyl glycoluril) (POWDERLINK [registered trademark] 1174), 1,3,4,6-tetrakis(butoxymethyl)glycoluril, 1,3,4,6-tetrakis(hydroxymethyl)glycoluril, 1,3-bis(hydroxymethyl)urea, 1,1,3,3-tetrakis(butoxymethyl)urea, and 1,1,3,3-tetraki s(methoxymethyl)urea.

In addition, the crosslinking agent may be a nitrogen-containing compound having 2 to 6 substituents represented by the following Formula (1d) bonded to a nitrogen atom in one molecule, which is disclosed in WO 2017/187969 A.

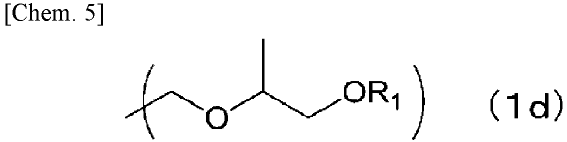

(In Formula (1d), R₁ represents a methyl group or an ethyl group.)

The nitrogen-containing compound having 2 to 6 substituents represented by Formula (1d) in one molecule may be a glycoluril derivative represented by the following Formula (1E).

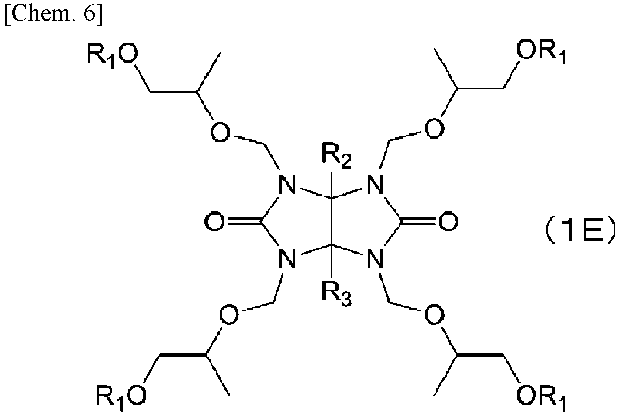

(In Formula (1E), four R₁'s each independently represent a methyl group or an ethyl group, and R₂ and R₃ each independently represent a hydrogen atom, an alkyl group having 1 to 4 carbon atoms, or a phenyl group.)

Examples of the glycoluril derivative represented by Formula (1E) include compounds represented by the following Formula (1E-1) to Formula (1E-6).

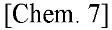

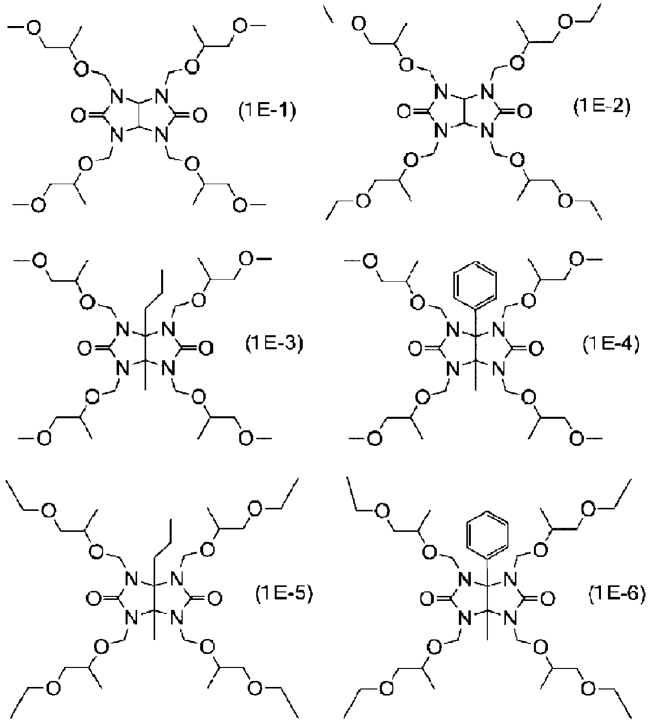

The nitrogen-containing compound having 2 to 6 substituents represented by Formula (1d) in one molecule is obtained by reacting a nitrogen-containing compound having 2 to 6 substituents bonded to a nitrogen atom and represented by the following Formula (2d) in one molecule with at least one compound represented by the following Formula (3d).

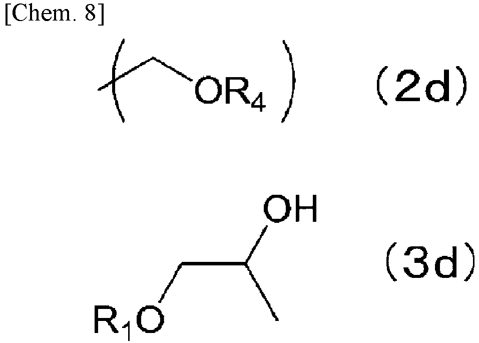

(In Formula (2d) and Formula (3d), R₁ represents a methyl group or an ethyl group and R₄ represents an alkyl group having 1 to 4 carbon atoms.)

The glycoluril derivative represented by Formula (1E) is obtained by reacting a glycoluril derivative represented by the following Formula (2E) with at least one compound represented by Formula (3d).

The nitrogen-containing compound having 2 to 6 substituents represented by Formula (2d) in one molecule is, for example, a glycoluril derivative represented by the following Formula (2E).

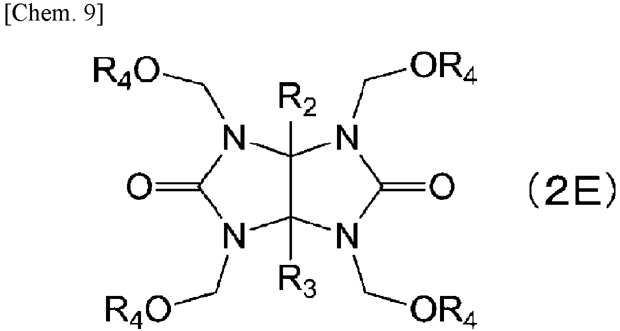

(In Formula (2E), R₂ and R₃ each independently represent a hydrogen atom, an alkyl group having 1 to 4 carbon atoms, or a phenyl group, and R₄'s each independently represent an alkyl group having 1 to 4 carbon atoms.)

Examples of the glycoluril derivative represented by Formula (2E) include compounds represented by the following Formula (2E-1) to Formula (2E-4). Further, examples of the compound represented by Formula (3d) include compounds represented by the following Formula (3d-1) and Formula (3d-2).

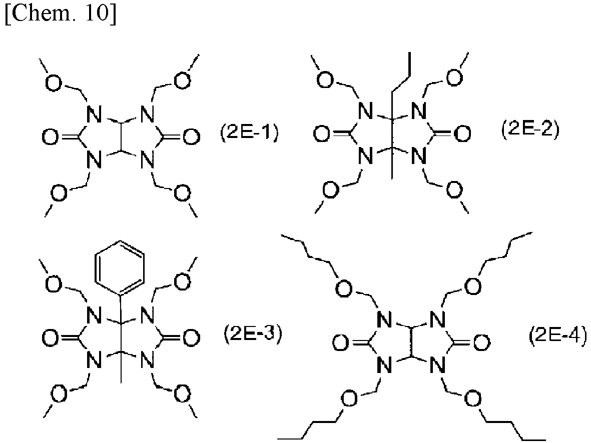

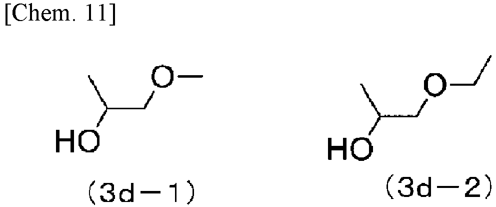

With regard to the detailed description of the nitrogen-containing compound having 2 to 6 substituents bonded to a nitrogen atom and represented by the following Formula (1d) in one molecule, the entire disclosure of WO 2017/187969 A is incorporated into the present application by reference.

These crosslinkable compounds may be used each alone or in combination of two or more thereof. In a case where the crosslinking agent is used, the content ratio thereof is usually within the range of 1% by mass to 50% by mass, and preferably, 5% by mass to 30% by mass, with respect to the reaction product. In addition, the content thereof is preferably within the range of 1 to 200 parts by weight with respect to 100 parts by weight of the polymer and/or compound, which contains a ring aromatic hydrocarbon group.

The photocurable resin composition according to the present invention may further contain a compound containing at least one partial structure selected from partial structures (I) represented by the following Formulas (1-1) to (1-7), which is disclosed in WO 2018/190380 A: 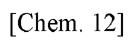 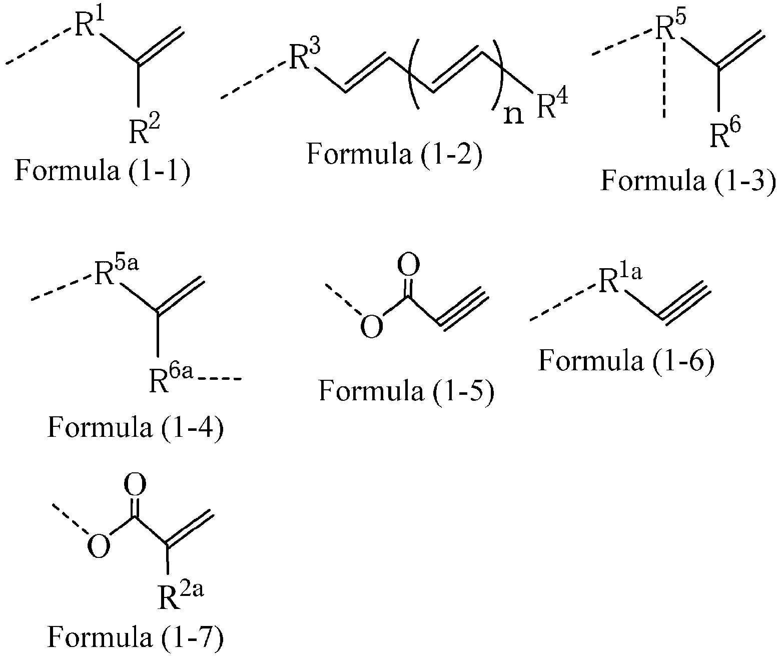
(in the formula, R¹, R^{1a}, R³, R^{5a}, and R^{6a} each independently represent an alkylene group having 1 to 10 carbon atoms, an arylene group having 6 to 40 carbon atoms (the alkylene group and the arylene group may be optionally substituted with one or two or more amide groups or amino groups), an oxygen atom, a carbonyl group, a sulfur atom, -C(O)-NR^{a}-, -NR^{b}-, or a divalent group consisting of a combination thereof,
R⁵'s each independently represent a nitrogen atom, or a trivalent group consisting of a combination of a nitrogen atom and at least one group selected from the group consisting of an alkylene group having 1 to 10 carbon atoms, an arylene group having 6 to 40 carbon atoms (the alkylene group and arylene group may be optionally substituted with one or two or more amide groups or amino groups), an oxygen atom, a carbonyl group, a sulfur atom, -C(O)-NR^{a}-, and -NR^{b}-,
R², R^{2a}, R⁴, and R⁶ each independently represent a hydrogen atom, an alkyl group having 1 to 10 carbon atoms, or a monovalent group consisting of a combination of a hydrogen atom and at least one group selected from the group consisting of an alkylene group having 1 to 10 carbon atoms, an oxygen atom, a carbonyl group, a sulfur atom, -C(O)-NR^{a}-, and -NR^{b}-,
R^{a} represents a hydrogen atom or an alkyl group having 1 to 10 carbon atoms,
R^{b} represents a hydrogen atom, an alkyl group having 1 to 10 carbon atoms, or an alkylcarbonyl group having 1 to 10 carbon atoms,
n represents the number of repeating units of 1 to 10, and
a dotted line represents a chemical bond to an adjacent atom).

The entire disclosure of WO 2018/190380 A is incorporated into the present application by reference.

The photocurable resin composition according to the present invention may further contain a polysiloxane. The polysiloxane may be a modified polysiloxane in which a part of silanol groups is modified, for example, a polysiloxane modified product in which a part of silanol groups is alcohol-modified or acetal-protected.

In addition, the polysiloxane may be, as an example, a hydrolysis condensate of hydrolyzable silanes, or may be a modified product in which at least a part of silanol groups of the hydrolysis condensate is alcohol-modified or acetal-protected (hereinafter, may be referred to as a "modified product of a hydrolysis condensate"). The hydrolyzable silane related to the hydrolysis condensate may include one or two or more hydrolyzable silanes.

The polysiloxane may have a structure having any of a cage type, ladder type, linear type, and branched type main chain. Further, commercially available polysiloxanes may be used.

Note that, in the present invention, the "hydrolysis condensate" of the hydrolyzable silane, that is, the product of the hydrolysis condensation includes not only a polyorganosiloxane polymer that is a condensate in which the condensation is completely completed, but also a polyorganosiloxane polymer that is a partial hydrolysis condensate in which the condensation is not completely completed. Such a partial hydrolysis condensate is also a polymer obtained by hydrolysis and condensation of a hydrolyzable silane similarly to a condensate in which condensation is completely completed, but the polymer is partially hydrolyzed and is not condensed, and therefore, a Si-OH group remains.

Examples of the polysiloxane include a hydrolysis condensate of hydrolyzable silanes containing at least one hydrolyzable silane represented by the following Formula (11) or a modified product thereof.
[Chem. 13]

R¹ₐSi(R²)₄₋ₐ (11)

In Formula (11), R¹ is a group bonded to a silicon atom, and independently represents an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group, an optionally substituted alkoxyaralkyl group, or an optionally substituted alkenyl group, or represents an organic group having an epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more thereof.

In addition, R² is a group or atom bonded to a silicon atom, and independently represents an alkoxy group, an aralkyloxy group, an acyloxy group, or a halogen atom.
a represents an integer of 0 to 3.

Specific examples of each group and atom in R¹ and suitable carbon number thereof in Formula (11) include the group and carbon number defined above for R³ in Formulas (A-1) and (A-2).

Specific examples of each group and atom in R² and suitable carbon number thereof in Formula (11) include the group and atom and carbon number defined above for X in Formulas (A-1) and (A-2).

Specific examples of the hydrolyzable silane represented by Formula (11) include, but are not limited to, tetramethoxysilane, tetrachlorosilane, tetraacetoxysilane, tetraethoxysilane, tetra-n-propoxysilane, tetra-i-propoxysilane, tetra-n-butoxysilane, methyltrimethoxysilane, methyltrichlorosilane, methyltriacetoxysilane, methyltriethoxysilane, methyltripropoxysilane, methyltributoxysilane, methyltriamyloxysilane, methyltriphenoxysilane, methyltribenzyloxysilane, methyltriphenethyloxysilane, glycidoxy methyltrimethoxysilane, glycidoxy methyltriethoxysilane, α-glycidoxy ethyltrimethoxysilane, α-glycidoxy ethyltriethoxysilane, β-glycidoxy ethyltrimethoxysilane, β-glycidoxy ethyltriethoxysilane, α-glycidoxy propyltrimethoxysilane, α-glycidoxy propyltriethoxysilane, β-glycidoxy propyltrimethoxysilane, β-glycidoxy propyltriethoxysilane, γ-glycidoxy propyltrimethoxysilane, γ-glycidoxy propyltriethoxysilane, γ-glycidoxy propyltripropoxysilane, γ-glycidoxy propyltributoxysilane, γ-glycidoxy propyltriphenoxysilane, α-glycidoxy butyltrimethoxysilane, α-glycidoxy butyltriethoxysilane, β-glycidoxy butyltriethoxysilane, γ-glycidoxy butyltrimethoxysilane, γ-glycidoxy butyltriethoxysilane, δ-glycidoxy butyltrimethoxysilane, δ-glycidoxy butyltriethoxysilane, (3,4-epoxycyclohexyl)methyltrimethoxysilane, (3,4-epoxycyclohexyl)methyltriethoxysilane, β-(3,4-epoxycyclohexyl)ethyltrimethoxysilane, β-(3,4-epoxycyclohexyl)ethyltriethoxysilane, β-(3,4-epoxycyclohexyl)ethyltripropoxysilane, β-(3,4-epoxycyclohexyl)ethyltributoxysilane, β-(3,4-epoxycyclohexyl)ethyltriphenoxysilane, γ-(3,4-epoxycyclohexyl)propyltrimethoxysilane, γ-(3,4-epoxycyclohexyl)propyltriethoxysilane, δ-(3,4-epoxycyclohexyl)butyltrimethoxysilane, δ-(3,4-epoxycyclohexyl)butyltriethoxysilane, glycidoxy methylmethyldimethoxysilane, glycidoxy methylmethyldiethoxysilane, α-glycidoxy ethylmethyldimethoxysilane, α-glycidoxy ethylmethyldiethoxysilane, β-glycidoxy ethylmethyldimethoxysilane, β-glycidoxy ethylethyldimethoxysilane, α-glycidoxy propylmethyldimethoxysilane, α-glycidoxy propylmethyldiethoxysilane, β-glycidoxy propylmethyldimethoxysilane, β-glycidoxy propylethyldimethoxysilane, γ-glycidoxy propylmethyldimethoxysilane, γ-glycidoxy propylmethyldiethoxysilane, γ-glycidoxy propylmethyldipropoxysilane, γ-glycidoxy propylmethyldibutoxysilane, γ-glycidoxy propylmethyldiphenoxysilane, γ-glycidoxy propylethyldimethoxysilane, γ-glycidoxy propylethyldiethoxysilane, γ-glycidoxy propylvinyldimethoxysilane, γ-glycidoxy propylvinyldiethoxysilane, ethyltrimethoxysilane, ethyltriethoxysilane, vinyltrimethoxysilane, vinyltriethoxysilane, vinyltrichlorosilane, vinyltriacetoxysilane, methylvinyldimethoxysilane, methylvinyldiethoxysilane, methylvinyldichlorosilane, methylvinyldiacetoxysilane, dimethylvinylmethoxysilane, dimethylvinylethoxysilane, dimethylvinylchlorosilane, dimethylvinylacetoxysilane, divinyldimethoxysilane, divinyldiethoxysilane, divinyldichlorosilane, divinyldiacetoxysilane, γ-glycidoxy propylvinyldimethoxysilane, γ-glycidoxy propylvinyldiethoxysilane, allyltrimethoxysilane, allyltriethoxysilane, allyltrichlorosilane, allyltriacetoxysilane, allylmethyldimethoxysilane, allylmethyldiethoxysilane, allylmethyldichlorosilane, allylmethyldimethoxysilane acetoxysilane, allyldimethylmethoxysilane, allyldimethylethoxysilane, allyldimethylchlorosilane, allyldimethylacetoxysilane, diallyldimethoxysilane, diallyldiethoxysilane, diallyldichlorosilane, diallyldiacetoxysilane, 3-allylaminopropyltrimethoxysilane, 3-allylaminopropyltriethoxysilane, p-styryltrimethoxysilane, phenyltrimethoxysilane, phenyltriethoxysilane, phenyltrichlorosilane, phenyltriacetoxysilane, phenylmethyldimethoxysilane, phenylmethyldiethoxysilane, phenylmethyldichlorosilane, phenylmethyldiacetoxysilane, phenyldimethylmethoxysilane, phenyldimethylethoxysilane, phenyldimethylchlorosilane, phenyldimethylacetoxysilane, diphenylmethylmethoxysilane, diphenylmethylethoxysilane, diphenylmethylchlorosilane, diphenylmethylacetoxysilane, diphenyldimethoxysilane, diphenyldiethoxysilane, diphenyldichlorosilane, diphenyldiacetoxysilane, triphenylmethoxysilane, triphenylethoxysilane, triphenylacetoxysilane, triphenylchlorosilane, 3-phenylaminopropyltrimethoxysilane, 3-phenylaminopropyltriethoxysilane, dimethoxymethyl-3-(3-phenoxypropylthiopropyl)silane, triethoxy((2-methoxy-4-(methoxymethyl)phenoxy)methyl)silane, benzyltrimethoxysilane, benzyltriethoxysilane, benzylmethyldimethoxysilane, benzylmethyldiethoxysilane, benzyldimethylmethoxysilane, benzyldimethylethoxysilane, benzyldimethylchlorosilane, phenethyltrimethoxysilane, phenethyltriethoxysilane, phenethyltrichlorosilane, phenethyltriacetoxysilane, phenethylmethyldimethoxysilane, phenethylmethyldiethoxysilane, phenethylmethyldichlorosilane, phenethylmethyldiacetoxysilane, methoxyphenyltrimethoxysilane, methoxyphenyltriethoxysilane, methoxyphenyltriacetoxysilane, methoxyphenyltrichlorosilane, methoxybenzyltrimethoxysilane, methoxybenzyltriethoxysilane, methoxybenzy1triacetoxysilane, methoxybenzyltrichlorosilane, methoxyphenethyltrimethoxysilane, methoxyphenethyltriethoxysilane, methoxyphenethyltriacetoxysilane, methoxyphenethyltrichlorosilane, ethoxyphenyltrimethoxysilane, ethoxyphenyltriethoxysilane, ethoxyphenyltriacetoxysilane, ethoxyphenyltrichlorosilane, ethoxybenzyltrimethoxysilane, ethoxybenzyltriethoxysilane, ethoxybenzyltiiacetoxysilane, ethoxybenzyltrichlorosilane, i-propoxyphenyltrimethoxysilane, i-propoxyphenyltriethoxysilane, i-propoxyphenyltriacetoxy silane, i-propoxyphenyltrichlorosilane, i-propoxybenzyltrimethoxysilane, i-propoxybenzyltriethoxysilane, i-propoxybenzyltriacetoxysilane, i-propoxybenzyltrichlorosilane, t-butoxyphenyltrimethoxysilane, t-butoxyphenyltriethoxysilane, t-butoxyphenyltriacetoxysilane, t-butoxyphenyltrichlorosilane, t-butoxybenzyl trimethoxysilane, t-butoxybenzyltriethoxysilane, t-butoxybenzyltriacetoxysilane, t-butoxybenzyltrichlorosilane, methoxynaphthyltrimethoxysilane, methoxynaphthyltriethoxysilane, methoxynaphthyltriacetoxysilane, methoxynaphthyltrichlorosilane, ethoxynaphthyltrimethoxysilane, ethoxynaphthyltriethoxysilane, ethoxynaphthyltriacetoxysilane, ethoxynaphthyltrichlorosilane, γ-chloropropyltrimethoxysilane, γ-chloropropyltriethoxysilane, γ-chloropropyltriacetoxysilane, 3,3,3-trifluoropropyltrimethoxysilane, γ-methacryloxypropyltrimethoxysilane, γ-mercaptopropyltrimethoxysilane, γ-mercaptopropyltriethoxysilane, β-cyanoethyltriethoxysilane, thiocyanatepropyltriethoxysilane, chloromethyltrimethoxysilane, chloromethyltriethoxysilane, triethoxysilylpropyl diallyl isocyanurate, bicyclo[2,2,1]heptenyltriethoxysilane, benzenesulfonylpropyltriethoxysilane, benzenesulfonamidopropyltriethoxysilane, dimethylaminopropyltrimethoxysilane, dimethyldimethoxysilane, phenylmethyldimethoxysilane, dimethyldiethoxysilane, phenylmethyldiethoxysilane, γ-chloropropylmethyldimethoxysilane, γ-chloropropylmethyldiethoxysilane, dimethyldiacetoxysilane, γ-methacryloxypropylmethyldimethoxysilane, γ-methacryloxypropylmethyldiethoxysilane, γ-mercaptopropylmethyldimethoxysilane, γ-mercaptomethyldiethoxysilane, methylvinyldimethoxysilane, and methylvinyldiethoxysilane.

The photocurable resin composition according to the present invention may further contain:
(A) a polyfunctional epoxy (meth)acrylate compound;
(B) a polyfunctional thiol compound; and
(C) a radical polymerization initiator, which are disclosed in JP 2016-003160 A.

The molecular weight of the component (A) may be within the range of 300 to 20,000.

The component (A) may be a bisphenol-type polyfunctional epoxy (meth)acrylate compound.

The component (B) may be liquid at 25°C.

Further, (D) a polymerization inhibitor may be contained.

The entire disclosure of JP 2016-003160 A is incorporated into the present application by reference.

The photocurable resin composition according to the present invention may be a film-forming composition further containing a photopolymerizable substance and a photopolymerization initiator disclosed in WO 2009/104643 A.

The photopolymerizable substance may be a compound having at least one cationically polymerizable reactive group, and the cationic polymerization initiator may be a photocationic polymerization initiator.

The photopolymerizable substance may be a compound having at least one radical polymerizable reactive group, and the photopolymerization initiator may be a photoradical polymerization initiator.

The photopolymerizable compound may be a sugar compound.

The sugar compound may be a monosaccharide or disaccharide compound.

The sugar compound may be Formula (10): 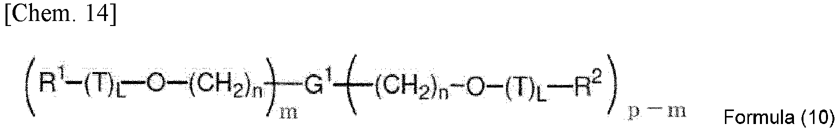 (wherein G¹ represents a sugar skeleton, T represents a divalent linking group, R¹ represents a vinyl group or a glycidyl group, and R² represents a hydrogen atom or a hydroxyl group, n and L each represent an integer of 0 or 1, and p is an integer and a total number of hydroxyl groups of the sugar, and m is an integer satisfying 1 ≤ m ≤ (p-m)).

The photopolymerizable compound may be an alicyclic epoxy compound or an alicyclic oxetane compound.

The alicyclic epoxy compound may be a cycloalkylene oxide derivative.

The alicyclic epoxy compound may be Formula (2) or Formula (3): 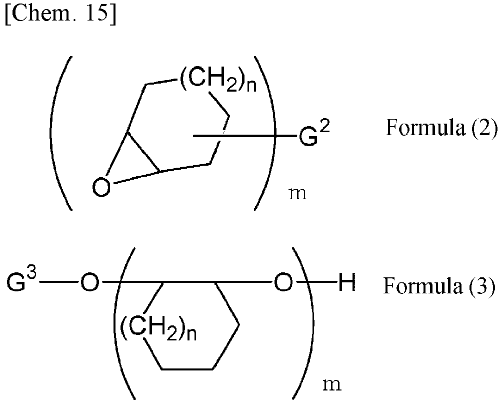 (wherein G² represents an alkylene group, a carbonyloxy group, a heterocyclic ring, an aromatic ring, or a monovalent to pentavalent linking group having a combination thereof, G³ represents an alkyl group, an alkylcarbonyl group, a heterocyclic ring, an aromatic ring, or an organic group having a combination thereof, and n and m each represent an integer of 1 to 5).

The entire disclosure of WO 2009/104643 A is incorporated into the present application by reference.

A method for preparing a photocurable resin composition of the present application is not particularly limited. That is, a polymer and/or compound, which contains a polycyclic aromatic hydrocarbon group, a solvent, and other components may be mixed in an arbitrary ratio and in an arbitrary order to form a uniform solution. The thus-prepared photocurable resin composition in a solution state is preferably used after filtration using a filter having a pore size of about 0.2 µm or the like.

In the photocurable resin composition according to the present invention, a solid content, that is, a concentration range of the components excluding the solvent may be appropriately selected according to the application. For example, the content is usually within the range of 5 to 50% by mass and preferably 10 to 30% by mass for forming a resist underlayer film, and is usually 0.01% by mass to 10% by mass for forming a wafer edge protective film for manufacturing a semiconductor.

### <Method for manufacturing semiconductor device>

The photocurable resin composition according to the present invention is applied onto a semiconductor substrate, and the applied composition is baked to produce a resist underlayer film, and a semiconductor device can be manufactured using the resist underlayer film.

Examples of the semiconductor substrate on which the photocurable resin composition according to the present invention is applied include a silicon wafer, a germanium wafer, and a semiconductor wafer formed of a compound such as gallium arsenide, indium phosphide, gallium nitride, indium nitride, or aluminum nitride.

In a case where a semiconductor substrate having a front surface on which an inorganic film is formed is used, the inorganic film is formed by, for example, an atomic layer deposition (ALD) method, a chemical vapor deposition (CVD) method, a reactive sputtering method, an ion-plating method, a vacuum deposition method, or a spin coating method (spin on glass: SOG). Examples of the inorganic film include a polysilicon film, a silicon oxide film, a silicon nitride film, a Boro-Phospho Silicate Glass (BPSG) film, a titanium nitride film, a titanium nitride oxide film, a tungsten film, a gallium nitride film, and a gallium arsenide film.

The photocurable resin composition according to the present invention is applied onto the semiconductor substrate by an appropriate application method such as a spinner or a coater. Thereafter, baking is performed using heating means such as a hot plate to form a resist underlayer film. The conditions for baking are appropriately selected from a baking temperature of 100°C to 400°C and a baking time of 0.3 minutes to 60 minutes. Preferably, the baking temperature is 120°C to 350°C and the baking time is 0.5 minutes to 30 minutes, and more preferably, the baking temperature is 150°C to 300°C and the baking time is 0.8 minutes to 10 minutes.

A thickness of a resist underlayer film to be formed is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (1 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), or 0.005 µm (5 nm) to 0.02 µm (20 nm).

A method for manufacturing a patterned substrate includes the following steps. Usually, a photoresist layer is formed on a resist underlayer film. A photoresist formed by performing application and baking on the resist underlayer film by a method known per se is not particularly limited as long as it is sensitive to light used for exposure. Either a negative photoresist or a positive photoresist may be used. Examples of the photoresist include a positive photoresist formed of a novolac resin and 1,2-naphthoquinonediazide sulfonic acid ester; a chemically amplified photoresist formed of a binder having a group degradable by an acid to increase an alkali dissolution rate and a photoacid generator; a chemically amplified photoresist formed of a low-molecular-weight compound degradable by an acid to increase an alkali dissolution rate of the photoresist, an alkali-soluble binder, and a photoacid generator; a chemically amplified photoresist formed of a binder having a group degradable by an acid to increase an alkali dissolution rate, a low-molecular-weight compound degradable by an acid to increase an alkali dissolution rate of the photoresist, and a photoacid generator; and a resist containing metal elements. Examples thereof include V146G (trade name) manufactured by JSR Corporation, APEX-E (trade name) manufactured by Shipley Company L.L.C, PAR710 (trade name) manufactured by Sumitomo Chemical Co., Ltd., and AR2772 and SEPR430 (trade name) manufactured by Shin-Etsu Chemical Co., Ltd. In addition, examples thereof include a fluorine-containing atomic polymer-based photoresist as described in Proc. SPIE, Vol. 3999, 330-334 (2000), Proc. SPIE, Vol. 3999, 357-364 (2000), and Proc. SPIE, Vol. 3999, 365-374 (2000).

In addition, the resist compositions disclosed in WO 2019/188595 A, WO 2019/187881 A, WO 2019/187803 A, WO 2019/167737 A, WO 2019/167725 A, WO 2019/187445 A, WO 2019/167419 A, WO 2019/123842 A, WO 2019/054282 A, WO 2019/058945 A, WO 2019/058890 A, WO 2019/039290 A, WO 2019/044259 A, WO 2019/044231 A, WO 2019/026549 A, WO 2018/193954 A, WO 2019/172054 A, WO 2019/021975 A, WO 2018/230334 A, WO 2018/194123 A, JP 2018-180525 A, WO 2018/190088 A, JP 2018-070596 A, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A, JP 2012-022258 A, JP 2011-043749 A, JP 2010-181857 A, JP 2010-128369 A, WO 2018/031896 A, JP 2019-113855 A, WO 2017/156388 A, WO 2017/066319 A, JP 2018-41099 A, WO 2016/065120 A, WO 2015/026482 A, JP 2016-29498 A, JP 2011-253185 A, and the like, the so-called resist compositions such as a radiation-sensitive resin composition and a high-resolution patterning composition based on an organometallic solution, and a metal-containing resist composition may be used, but are not limited thereto.

Examples of the resist composition include the following compositions.

An active ray-sensitive or radiation-sensitive resin composition containing: a resin A having a repeating unit having an acid-decomposable group in which a polar group is protected by a protecting group that is desorbed by an action of an acid; and a compound represented by General Formula (21).

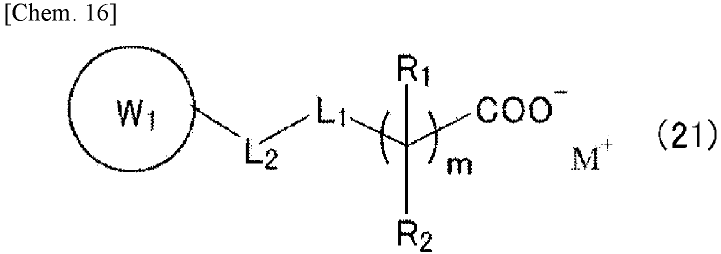

In General Formula (21), m represents an integer of 1 to 6.

R₁ and R₂ each independently represent a fluorine atom or a perfluoroalkyl group.

L₁ represents -O-, -S-, -COO-, -SO₂-, or -SO₃-.

L₂ represents an alkylene group which may have a substituent or a single bond. W₁ represents a cyclic organic group which may have a substituent.

M⁺ represents a cation.

A metal-containing film-forming composition for extreme ultraviolet ray or electron beam lithography, containing: a compound having a metal-oxygen covalent bond; and a solvent, in which metal elements constituting the compound belong to the third to seventh periods of Groups 3 to 15 of the periodic table.

A radiation-sensitive resin composition containing: a polymer having a first structural unit represented by the following Formula (31) and a second structural unit having an acid-dissociable group represented by the following Formula (32); and an acid generator.

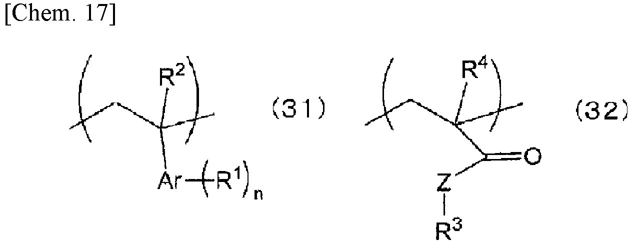

(In Formula (31), Ar is a group obtained by removing (n+1) hydrogen atoms from arene having 6 to 20 carbon atoms. R¹ is a hydroxy group, a sulfanyl group, or a monovalent organic group having 1 to 20 carbon atoms. n is an integer of 0 to 11. When n is 2 or more, a plurality of R¹'s are the same as or different from each other. R² is a hydrogen atom, a fluorine atom, a methyl group, or a trifluoromethyl group. In Formula (32), R³ is a monovalent group having 1 to 20 carbon atoms which has the acid-dissociable group. Z is a single bond, an oxygen atom, or a sulfur atom. R⁴ is a hydrogen atom, a fluorine atom, a methyl group, or a trifluoromethyl group.)

A resist composition containing: a resin (A1) having a structural unit having a cyclic carbonic acid ester structure, a structural unit represented by the following formula, and a structural unit having an acid-unstable group; and an acid generator.

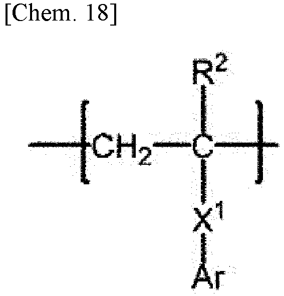

[In the formula,
R² represents an alkyl group having 1 to 6 carbon atoms which may have a halogen atom, a hydrogen atom, or a halogen atom, X¹ represents a single bond, -CO-O-*, or -CO-NR⁴-*, * represents a bond with -Ar, R⁴ represents a hydrogen atom or an alkyl group having 1 to 4 carbon atoms, and Ar represents an aromatic hydrocarbon group having 6 to 20 carbon atoms which may have one or more groups selected from the group consisting of a hydroxy group and a carboxyl group.]

Examples of the resist film include the following.

A resist film containing a base resin having a repeating unit represented by the following Formula (a1) and/or a repeating unit represented by the following Formula (a2), and a repeating unit that generates an acid bonded to a polymer main chain by exposure.

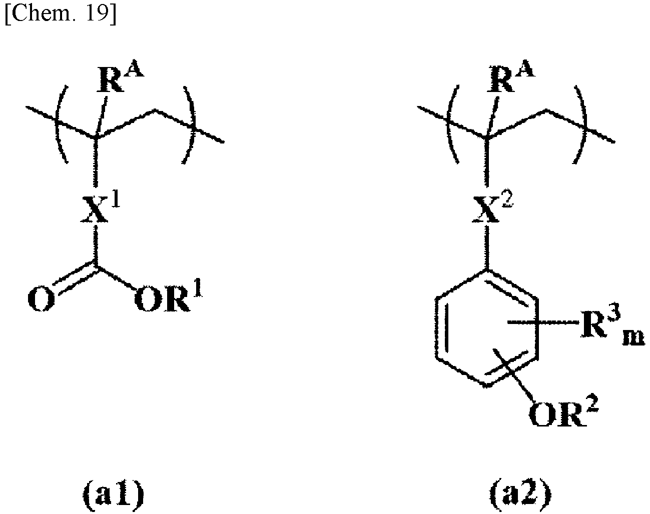

(In Formula (a1) and Formula (a2), R^{A}'s are each independently a hydrogen atom or a methyl group. R¹ and R² are each independently a tertiary alkyl group having 4 to 6 carbon atoms. R³'s each independently represent a fluorine atom or a methyl group. m is an integer of 0 to 4. X¹ is a single bond, a phenylene group or a naphthylene group, or a linking group having 1 to 12 carbon atoms containing at least one selected from an ester bond, a lactone ring, a phenylene group, and a naphthylene group. X² is a single bond, an ester bond, or an amide bond.)

Examples of a resist material include the following.

A resist material containing a polymer having a repeating unit represented by the following Formula (b1) or Formula (b2).

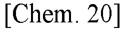

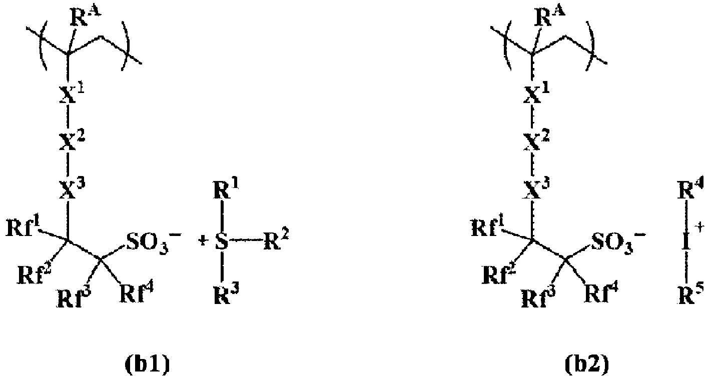

(In Formula (b 1) and Formula (b2), R^{A} is a hydrogen atom or a methyl group. X¹ is a single bond or an ester group. X² is a linear, branched, or cyclic alkylene group having 1 to 12 carbon atoms or an arylene group having 6 to 10 carbon atoms, a part of a methylene group constituting the alkylene group may be substituted with an ether group, an ester group, or a lactone ring-containing group, and at least one hydrogen atom contained in X² is substituted with a bromine atom. X³ is a single bond, an ether group, an ester group, or a linear, branched, or cyclic alkylene group having 1 to 12 carbon atoms, and a part of a methylene group constituting the alkylene group may be substituted with an ether group or an ester group. Rf¹ to Rf⁴ are each independently a hydrogen atom, a fluorine atom, or a trifluoromethyl group, and at least one of Rf¹ to Rf⁴ is a fluorine atom or a trifluoromethyl group. In addition, Rf¹ and Rf² may be combined to form a carbonyl group. R¹ to R⁵ each independently represent a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, some or all of the hydrogen atoms in these groups may be substituted with a hydroxy group, a carboxy group, a halogen atom, an oxo group, a cyano group, an amide group, a nitro group, a sultone group, a sulfone group, or a sulfonium salt-containing group, and a part of a methylene group constituting each of these groups may be substituted with an ether group, an ester group, a carbonyl group, a carbonate group, or a sulfonic acid ester group. In addition, R¹ and R² may be bonded to form a ring together with a sulfur atom to which they are bonded.)

A resist material containing a base resin containing a polymer having a repeating unit represented by the following Formula (a).

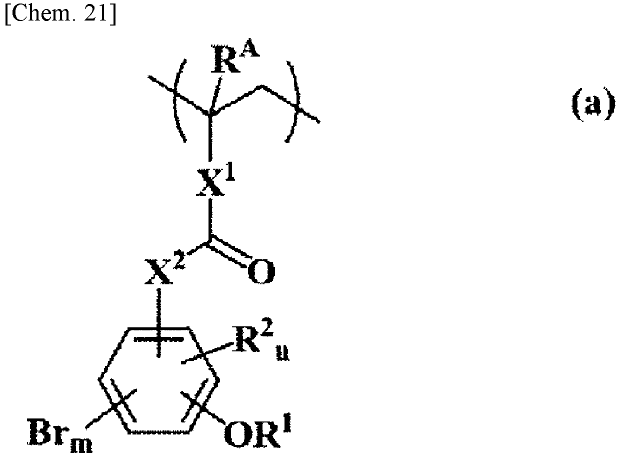

(In Formula (a), R^{A} is a hydrogen atom or a methyl group. R¹ is a hydrogen atom or an acid-unstable group. R² is a linear, branched, or cyclic alkyl group having 1 to 6 carbon atoms or a halogen atom other than bromine. X¹ is a single bond or a phenylene group, or a linear, branched, or cyclic alkylene group having 1 to 12 carbon atoms which may contain an ester group or a lactone ring. X² is -O-, -O-CH₂-, or - NH-. m is an integer of 1 to 4. n is an integer of 0 to 3.)

A resist composition which generates an acid by exposure and has solubility in a developer that is changed by an action of the acid, the resist composition containing:
a base component (A) having solubility in a developer that is changed by an action of an acid; and a fluorine additive component (F) exhibiting decomposability in an alkaline developer,
in which the fluorine additive component (F) contains a fluororesin component (F1) having a structural unit (f1) containing a base-dissociable group and a structural unit (f2) containing a group represented by the following General Formula (f2-r-1).

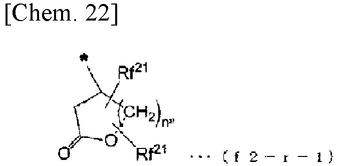

[In Formula (f2-r-1), Rf²¹'s each independently represent a hydrogen atom, an alkyl group, an alkoxy group, a hydroxyl group, a hydroxyalkyl group, or a cyano group. n" is an integer of 0 to 2. * represents a bond.]

The structural unit (f1) includes a structural unit represented by the following General Formula (f1-1) or a structural unit represented by the following General Formula (f1-2).

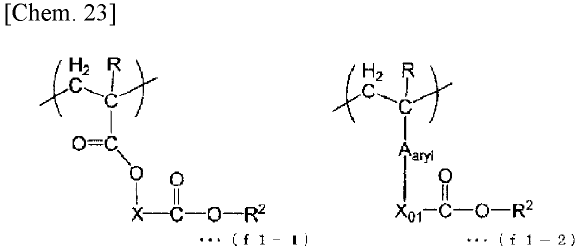

[In Formulas (f1-1) and (f1-2), R's are each independently a hydrogen atom, an alkyl group having 1 to 5 carbon atoms, or a halogenated alkyl group having 1 to 5 carbon atoms. X is a divalent linking group having no acid-dissociable site. A_{aryl} is a divalent aromatic cyclic group which may have a substituent. X₀₁ is a single bond or a divalent linking group. R²'s are each independently an organic group having a fluorine atom.]

Examples of the coating, the coating solution, and the coating composition include the following.

A coating containing a metal oxo-hydroxo network having an organic ligand by a metal carbon bond and/or a metal carboxylate bond.

Inorganic oxo/hydroxo-based composition.

A coating solution containing: an organic solvent; a first organometallic composition represented by Formula R_{z}SnO_{(2-(z/2)-(x/2))}(OH)ₓ (where 0 < z ≤ 2 and 0 < (z + x) ≤ 4), Formula R'ₙSnX₄₋ₙ (where n = 1 or 2), or a mixture thereof, where R and R' are independently a hydrocarbyl group having 1 to 31 carbon atoms, and X is a ligand having a hydrolyzable bond to Sn or a combination thereof; and a hydrolyzable metal compound represented by MX'ᵥ (where M is a metal selected from Groups 2 to 16 of the periodic table of the elements, v = number of 2 to 6, and X' is a ligand having a hydrolyzable M-X bond or a combination thereof).

A coating solution containing: an organic solvent; and a first organometallic composition represented by Formula RSnO_{(3/2-x/2)}(OH)ₓ (in the formula, 0 < x < 3), in which about 0.0025 M to about 1.5 M tin is contained in the solution, R is an alkyl group or cycloalkyl group having 3 to 31 carbon atoms, and the alkyl group or cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

The exposure is performed through a mask (reticle) for forming a predetermined pattern, and for example, an i-line, a KrF energy laser, an ArF energy laser, an extreme ultraviolet ray (EUV), or an electron beam (EB) is used, but the resist underlayer film-forming composition of the present application is preferably applied for electron beam (EB) or extreme ultraviolet ray (EUV) exposure, and more preferably for extreme ultraviolet ray (EUV) exposure. In the development, an alkaline developer is used, and a development temperature and a development time are appropriately selected from 5°C to 50°C and 10 seconds to 300 seconds, respectively. As the alkaline developer, for example, aqueous solutions of alkalis, for example, inorganic alkalis such as sodium hydroxide, potassium hydroxide, sodium carbonate, sodium silicate, sodium metasilicate, and ammonia water, primary amines such as ethylamine and n-propylamine, secondary amines such as diethylamine and di-n-butyl amine, tertiary amines such as triethylamine and methyldiethylamine, alcoholamines such as dimethylethanolamine and triethanolamine, quaternary ammonium salts such as tetramethylammonium hydroxide, tetraethylammonium hydroxide, and choline, and cyclic amines such as pyrrole and piperidine, may be used. Furthermore, an appropriate amount of alcohols such as isopropyl alcohol and a surfactant such as a nonionic surfactant may be added to the aqueous solution of alkalis. Of these, a preferred developer is a quaternary ammonium salt and more preferably tetramethylammonium hydroxide and choline. Furthermore, a surfactant or the like may be added to the developer. Instead of the alkaline developer, a method of performing development with an organic solvent such as butyl acetate and developing a portion where an alkali dissolution rate of the photoresist is not increased may also be used. Through the above steps, a substrate on which the resist is patterned can be manufactured.

Next, the resist underlayer film is dry-etched using the formed resist pattern as a mask. At this time, in a case where the inorganic film is formed on the surface of the used semiconductor substrate, when the inorganic film is not formed on the surface of the used semiconductor substrate by exposing the surface of the inorganic film, the surface of the semiconductor substrate is exposed. Thereafter, the semiconductor device can be manufactured through a step of processing the substrate by a method known per se (a dry etching method or the like).

### <Method for manufacturing semiconductor device including step of forming wafer edge protective film>

The photocurable resin composition according to the present invention can be used for forming a wafer edge protective film for manufacturing a semiconductor.

Hereinafter, a case where the photocurable resin composition according to the present invention is used for forming a wafer edge protective film for manufacturing a semiconductor will be described.

A method for manufacturing a semiconductor device according to the present invention comprises the steps of:
(A) forming a resist film on a semiconductor substrate;
(B) forming a resist pattern by irradiation of the resist film with a light or electron beam and subsequent development; and
(C) processing the semiconductor substrate by etching,
which further includes step (X) of forming a protective film of the photocurable resin composition according to the present invention on a front surface edge and optionally on a bevel portion and/or back surface edge of a wafer for manufacturing a semiconductor.

Hereinafter, the method will be described in order.

### [Step (A) of forming resist film on semiconductor substrate]

A resist film is formed on a semiconductor substrate. The semiconductor substrate is a wafer used for manufacturing a semiconductor element or the like, and in addition to a generally used silicon wafer and germanium wafer, for example, a compound semiconductor wafer formed by bonding two or more elements such as gallium arsenide, indium phosphide, gallium nitride, indium nitride, and aluminum nitride may be used. The semiconductor substrate usually has a disk shape, and a size thereof is, for example, 4, 6, 8, or 12 inches, or the like. A commercially available product may be used.

In a case where a semiconductor substrate having a front surface on which an inorganic film is formed is used, the inorganic film is formed by, for example, an atomic layer deposition (ALD) method, a chemical vapor deposition (CVD) method, a reactive sputtering method, an ion-plating method, a vacuum deposition method, or a spin coating method (spin on glass: SOG). Examples of the inorganic film include a polysilicon film, a silicon oxide film, a silicon nitride film, a Boro-Phospho Silicate Glass (BPSG) film, a titanium nitride film, a titanium nitride oxide film, a tungsten film, a gallium nitride film, and a gallium arsenide film.

On such a semiconductor substrate, a resist underlayer film, a resist film, and the like having predetermined thicknesses are formed by an appropriate application method such as a spray, a spinner, or a coater. In general, in a case of a rotary coating method, each of the resist underlayer film-forming composition, the resist film-forming composition, and the like is supplied from above the central portion of the rotating disk-shaped substrate through a nozzle or the like. Usually, these films are baked using a heating means such as a hot plate.

In order to produce a protective film having a film thickness of about 300 nm by a rotary coating method, the photocurable resin composition according to the present invention as a protective film-forming composition preferably has a viscosity of about 100 cps or less at 25°C. Note that, in the present invention, the viscosity is a value measured by an E-type viscometer.

A photoresist used for forming a resist film is not particularly limited as long as it is sensitive to light used for exposure. Either a negative photoresist or a positive photoresist may be used. Examples of the photoresist include a positive photoresist formed of a novolac resin and 1,2-naphthoquinonediazide sulfonic acid ester; a chemically amplified photoresist formed of a binder having a group degradable by an acid to increase an alkali dissolution rate and a photoacid generator; a chemically amplified photoresist formed of a low-molecular-weight compound degradable by an acid to increase an alkali dissolution rate of the photoresist, an alkali-soluble binder, and a photoacid generator; a chemically amplified photoresist formed of a binder having a group degradable by an acid to increase an alkali dissolution rate, a low-molecular-weight compound degradable by an acid to increase an alkali dissolution rate of the photoresist, and a photoacid generator; and a resist containing metal elements. Examples thereof include V146G (trade name) manufactured by JSR Corporation, APEX-E (trade name) manufactured by Shipley Company L.L.C, PAR710 (trade name) manufactured by Sumitomo Chemical Co., Ltd., and AR2772 and SEPR430 (trade name) manufactured by Shin-Etsu Chemical Co., Ltd. In addition, examples thereof include a fluorine-containing atomic polymer-based photoresist as described in Proc. SPIE, Vol. 3999, 330-334 (2000), Proc. SPIE, Vol. 3999, 357-364 (2000), and Proc. SPIE, Vol. 3999, 365-374 (2000). A negative photoresist is preferable.

The resist film-forming composition used for forming the resist film may contain one or more metals. Examples of the form of the metal include a metal salt, a metal complex, and other metal-containing compounds in addition to a simple metal. The kind of the metal is not particularly limited, and examples thereof include tin, indium, antimony, bismuth, gallium, germanium, aluminum, zirconium, hafnium, cerium, lanthanum, and cesium.

The conditions for baking the resist film are appropriately selected from a bake temperature of 70°C to 400°C and a bake time of 0.3 minutes to 60 minutes. Preferably, the bake temperature is 80°C to 350°C and the bake time is 0.5 minutes to 30 minutes, and more preferably, the bake temperature is 90°C to 300°C and the bake time is 0.8 minutes to 10 minutes.

The lower limit of the average thickness of the resist film is preferably 1 nm and more preferably 3 nm, 5 nm, or 10 nm. The upper limit of the average thickness of the resist film is 5,000 nm, 3,000 nm, or 2,000 nm, preferably 1,000 nm, more preferably 500 nm or 200 nm, and still more preferably 50 nm.

### [Step (X) of forming protective film]

Step (X) of forming the protective film formed of the photocurable resin composition on the front surface edge and optionally on the bevel portion and/or back surface edge of the wafer for manufacturing a semiconductor is performed at an arbitrary time point. In step (X), preferably, the photocurable resin composition is applied, and exposure and development are performed on a predetermined region. Step (X) may be performed before step (A), may be performed between step (A) and step (B), or may be performed after step (B) or step (C).

Note that, in the present specification, a surface of a substrate on which a device portion such as a resist film is provided is referred to as a front surface, and a surface on the opposite side is referred to as a back surface. In addition, the front surface edge refers to a region having a width of usually 1 to 10 mm from an end of the device portion provided on the substrate to the bevel portion, the bevel portion refers to a curved region connecting the front surface edge and the back surface edge, and the back surface edge refers to a region of the back surface of the substrate opposite to the front surface edge.

First, a photocurable resin composition according to the present invention is applied to a semiconductor substrate on which a resist film and the like are formed. A method for applying the photocurable resin composition is not particularly limited, and for example, a known means such as a rotary coating method (spin coating method) or a spraying method may be adopted. For example, when a rotary coating method is adopted, the photocurable resin composition is supplied through a nozzle from above or near the front surface edge of a rotating disk-shaped substrate while rotating the semiconductor substrate on which a resist film and the like are formed at a predetermined rotation speed. Preferably, the bevel portion and/or back surface edge of the substrate is also supplied from the vicinity of each of the bevel portion and the back surface edge through a nozzle.

The conditions for the rotary coating may be appropriately selected, and are not limited at all, but typical conditions are as follows.
· Viscosity of photocurable resin composition: about 100 cps or less
· Rotation speed of wafer:
   · · At time of supplying photocurable resin composition: 50 to 500 rpm
   · · At time of shaking off for drying: 700 to 2,000 rpm
   · Thickness of protective film: 300 nm

Next, the photocurable resin composition is exposed. The exposure may be performed by irradiating the photocurable resin composition with an active ray (an i-ray, a KrF excimer laser, an ArF excimer laser, an extreme ultraviolet ray (EUV), or an electron beam (EB)) such as an ultraviolet ray, a visible ray, or a radiation through a mask or without a mask. Note that soft bake (SB) may be performed before exposure, or post-exposure bake (PEB) may be performed before development after exposure. The post-exposure bake temperature is preferably 50°C to 150°C, and a post-exposure bake time is preferably 1 minute to 10 minutes.

The photocurable resin composition is cured by light having a wavelength of preferably 170 to 800 nm (more preferably 200 to 600 nm, and still more preferably 300 to 500 nm).

Next, the photocurable resin composition after exposure is developed. The development may be performed by removing an exposed portion of the photocurable resin composition after exposure with a developer, and the development temperature and development time are appropriately selected from 5°C to 50°C and 10 seconds to 300 seconds, respectively.

Examples of an organic solvent contained in the developer include an alcohol-based solvent, an ether-based solvent, a ketone-based solvent, an amide-based solvent, an ester-based solvent, and a hydrocarbon-based solvent. As the organic solvent in the developer, an ester-based solvent, a ketone-based solvent, or a combination thereof is preferably contained. The developer may contain one organic solvent alone or two or more organic solvents.

Examples of the alcohol-based solvent include an aliphatic monoalcohol-based solvent having 1 to 18 carbon atoms such as 4-methyl-2-pentanol or n-hexanol; an alicyclic monoalcohol-based solvent having 3 to 18 carbon atoms such as cyclohexanol; and a polyhydric alcohol partial ether-based solvent having 3 to 19 carbon atoms such as propylene glycol monomethyl ether.

Examples of the ether-based solvent include a dialkyl ether-based solvent such as diethyl ether, dipropyl ether, dibutyl ether, dipentyl ether, diisoamyl ether, dihexyl ether, or diheptyl ether; a cyclic ether-based solvent such as tetrahydrofuran or tetrahydropyran; and an aromatic ring-containing ether-based solvent such as diphenyl ether or anisole.

Examples of the ketone-based solvent include a chain ketone-based solvent such as acetone, methyl ethyl ketone, methyl-n-propyl ketone, methyl-n-butyl ketone, diethyl ketone, methyl-iso-butyl ketone, 2-heptanone, ethyl-n-butyl ketone, methyl-n-hexyl ketone, di-iso-butyl ketone, or trimethylnonanone; a cyclic ketone-based solvent such as cyclopentanone, cyclohexanone, cycloheptanone, cyclooctanone, or methylcyclohexanone; and 2,4-pentanedione, acetonylacetone, and acetophenone.

Examples of the amide-based solvent include a cyclic amide-based solvent such as N,N'-dimethylimidazolidinone or N-methylpyrrolidone; and a chain amide-based solvent such as N-methylformamide, N,N-dimethylformamide, N,N-diethylformamide, acetamide, N-methylacetamide, N,N-dimethylacetamide, or N-methylpropionamide.

Examples of the ester-based solvent include a monocarboxylic acid ester-based solvent such as n-butyl acetate or ethyl lactate; a polyhydric alcohol carboxylate-based solvent such as propylene glycol acetate; a polyhydric alcohol partial ether carboxylate-based solvent such as propylene glycol monomethyl ether acetate; a polyhydric carboxylic acid diester-based solvent such as diethyl oxalate; and a carbonate-based solvent such as dimethyl carbonate or diethyl carbonate.

Examples of the hydrocarbon-based solvent include an aliphatic hydrocarbon-based solvent having 5 to 12 carbon atoms such as n-pentane or n-hexane; and an aromatic hydrocarbon-based solvent having 6 to 16 carbon atoms such as toluene or xylene.

Of these, an ester-based solvent, a ketone-based solvent, an ether-based solvent, and a combination thereof are preferable, and an ester-based solvent, a ketone-based solvent, and a combination thereof are more preferable. As the ester-based solvent, propylene glycol monomethyl ether acetate is preferable. As the ketone-based solvent, cyclohexanone is preferable. As the ether-based solvent, propylene glycol monomethyl ether is preferable.

The lower limit of a content of the organic solvent in the developer is preferably 80% by mass, more preferably 90% by mass, still more preferably 99% by mass, and particularly preferably 100% by mass. When the content of the organic solvent in the developer is within the above range, the dissolution contrast between the exposed portion and the unexposed portion can be improved, and as a result, a resist pattern having a better lithography performance can be formed. Examples of components other than the organic solvent include water and silicone oil.

The developer may contain a nitrogen-containing compound. When the developer contains the nitrogen-containing compound, film loss in the formed resist pattern can be further reduced.

As the developer, a developer of an aqueous solution may be used instead of the organic solvent-based developer. Specifically, the developer may be an aqueous alkali solution such as sodium hydroxide, potassium hydroxide, sodium silicate, ammonia, monoethylamine, diethylamine, triethylamine, triethanolamine, or tetramethylammonium hydroxide. The base concentration of the aqueous solution is not particularly limited, and may be, for example, within the range of 0.1 to 10% by mass.

In addition, alcohols or a surfactant may be added to the developer. Each of the alcohols or surfactant may be blended within the range of preferably 0.01 to 10 parts by weight and more preferably 0.1 to 5 parts by weight with respect to 100 parts by weight of the developer. Examples of the surfactant include an ionic or nonionic fluorine-based surfactant and a silicone-based surfactant.

Examples of the developing method include a method in which a substrate is immersed in a tank filled with a developer for a certain period of time (dipping method), a method in which a developer is raised on a surface of a substrate by surface tension and is stopped for a certain period of time (paddle method), a method in which a developer is sprayed onto a surface of a substrate (spraying method), and a method in which a developer is continuously applied onto a substrate rotating at a certain speed while a developer application nozzle is scanned at a certain speed (dynamic dispensing method).

Next, the photocurable resin composition after development is baked. A desired pattern can be formed by baking the pattern obtained after development. A heating temperature in the heat treatment is usually 150°C or higher and 350°C or lower, and preferably within the range of 200 to 300°C. The heat treatment time is a time until the photocurable resin composition is cured, and is preferably about shorter than 30 minutes in consideration of productivity.

The lower limit of the average thickness of the protective film is, for example, 1 nm, 3 nm, 5 nm, 10 nm, 30 nm, 50 nm, 80 nm, 100 nm, 150 nm, or 200 nm. The upper limit of the average thickness of the protective film is, for example, 10 µm, 8 µm, 5 µm, 3 µm, 1 µm, 800 nm, 500 nm, or 300 nm.

As the properties of the protective film that covers the edge of the substrate (wafer) for manufacturing a semiconductor, in addition to the function of preventing metal contamination of the wafer edge, it is desirable to satisfy dry etching resistance, phosphoric acid resistance, tetramethylammonium hydroxide (TMAH) resistance, HF removability, scratch resistance, excellent embeddability in a stepped substrate, a low sublimation amount, affinity to a hydrophobic substrate, leaving no crater foreign substance or the like on the side surface of the wafer, an excellent edge shape, a function of suppressing inner humps (a phenomenon in which a film-forming composition remains in a bump shape immediately below an injection hole of a nozzle), and the like.

In addition, in the case of the photocurable resin composition according to the present invention, the photosensitive photocurable resin composition (negative type) is applied to the front surface edge and optionally the bevel portion and/or back surface edge of the substrate, and then a portion where a film is to be cured is exposed and developed, such that the bevel portion can be accurately covered with the protective film. Due to the photosensitivity, it is possible to easily control the film thickness of the protective film on the edge face of the wafer, which is advantageous in that the inner humps can be removed, the edge shape can be improved, and a deviation of the center position at the time of rotary coating can be corrected.

After step (X), in step (Y), the resist film formed on the protective film may be removed with a removing solution. In this case, as in step (X), it is preferable to apply the removing solution to the front surface edge and optionally the bevel portion and/or back surface edge of the wafer for manufacturing a semiconductor. Examples of the resist removing solution include a mixed solution formed of propylene glycol monomethyl ether, propylene glycol monomethyl ether acetate, cyclohexanone, water, butyl acetate, a tetramethylammonium aqueous solution, or a combination thereof. Of these, propylene glycol monomethyl ether acetate and water are preferable from the viewpoint of removability of the resist film.

After step (X) or step (Y), in step (Z), the protective film may be removed by ashing or a treatment with hydrofluoric acid, an organic solvent, an alkaline developer, or a semiconductor cleaning solution. Thereafter, cleaning is preferably performed with an arbitrary solvent, a conventional semiconductor cleaning solution, or the like.

Steps (X), (Y), and (Z) may be performed simultaneously with steps (A), (B), and (C), or at any time before and after each step. For example, in a case where step (X) is included before step (A), step (Y) of removing the resist film formed on the protective film may be carried out between step (A) and step (B), and step (Z) of removing the protective film may be carried out between step (Y) and step (B). In addition, in a case where step (X) is included between step (A) and either step (B) or step (C), step (Z) of removing the protective film may be carried out between step (X) and either step (B) or step (C).

[Step (B) of forming resist pattern by irradiation of resist film with light or electron beam and subsequent development and step (C) of processing semiconductor substrate by etching]

The exposure of the resist film is performed through a mask (reticle) for forming a predetermined pattern, and for example, an i-ray, a KrF energy laser, an ArF energy laser, an extreme ultraviolet ray (EUV), or an electron beam (EB) is used. Note that soft bake (SB) may be carried out before exposure, or post-exposure bake (PEB) may be carried out before development after exposure. A post-exposure bake temperature is preferably 50°C to 150°C, and a post-exposure bake time is preferably 1 minute to 10 minutes.

In the development, an alkaline developer is used, and a development temperature and a development time are appropriately selected from 5°C to 50°C and 10 seconds to 300 seconds, respectively. As the alkaline developer, for example, aqueous solutions of alkalis, for example, inorganic alkalis such as sodium hydroxide, potassium hydroxide, sodium carbonate, sodium silicate, sodium metasilicate, and ammonia water, primary amines such as ethylamine and n-propylamine, secondary amines such as diethylamine and di-n-butyl amine, tertiary amines such as triethylamine and methyldiethylamine, alcoholamines such as dimethylethanolamine and triethanolamine, quaternary ammonium salts such as tetramethylammonium hydroxide, tetraethylammonium hydroxide, and choline, and cyclic amines such as pyrrole and piperidine, may be used. The base concentration of the aqueous solution is not particularly limited, and may be, for example, within the range of 0.1 to 10% by mass.

Moreover, an appropriate amount of alcohols such as isopropyl alcohol and a surfactant such as a nonionic surfactant may be added to the aqueous solution of alkalis. Each of the alcohols or surfactant may be blended within the range of preferably 0.01 to 10 parts by weight and more preferably 0.1 to 5 parts by weight with respect to 100 parts by weight of the developer. Of these, a preferred developer is a quaternary ammonium salt and more preferably tetramethylammonium hydroxide and choline. Furthermore, a surfactant or the like may be added to the developer.

A method of performing development using an organic solvent such as a polyhydric alcohol-based solvent having 2 to 18 carbon atoms such as 1,2-propylene glycol or butyl acetate instead of the alkaline developer, and developing a portion where an alkali dissolution rate of the photoresist is not increased may also be used.

The semiconductor substrate subjected to the exposure and development is baked. The means for baking is not particularly limited, and for example, a proximity bake furnace for securing a gap using a plurality of substrate support pins between a substrate and a hot plate is suitably used.

The bake temperature is usually within the range of 40°C to 300°C and preferably 200 to 300°C for 1 to 30 minutes, and may be set to 90°C or lower in a case where it is required to avoid damage to the resist pattern.

The baking may be performed on the semiconductor substrate before the post-exposure development. The means and conditions of the baking are as described above, and may be set to 90°C or lower when it is required to avoid damage to the resist pattern.

Next, the resist underlayer film is etched and preferably dry-etched using the formed resist pattern as a mask, to form a patterned resist. At this time, in the case where an inorganic film is formed on a surface of the semiconductor substrate used, a surface of the inorganic film is bared; and in the case where an inorganic film is not formed on a surface of the semiconductor substrate used, a surface of the semiconductor substrate is bared. Thereafter, the semiconductor substrate is processed using the patterned resist by a method known per se (dry etching method or the like).

The etching for processing the semiconductor substrate may be a known method. For example, in a case where the semiconductor substrate is a silicon substrate, the etching also includes a surface treatment step such as removing a silicon nitride film present on a surface of the semiconductor substrate with thermal phosphoric acid in addition to a step of performing shape processing by dry etching using a fluorine-based gas such as carbon tetrafluoride.

A semiconductor device can be manufactured through the above steps.

### <Method for manufacturing wafer for manufacturing semiconductor>

A method for manufacturing a wafer for manufacturing a semiconductor according to the present invention includes a step of applying the photocurable resin composition according to the present invention to a front surface edge and optionally a bevel portion and/or back surface edge of a wafer precursor for manufacturing a semiconductor to manufacture a wafer for manufacturing a semiconductor with a protective film in the method for manufacturing a semiconductor device as described above.

The wafer precursor for manufacturing a semiconductor refers to a precursor obtained by subjecting a semiconductor substrate to at least one step of the method for manufacturing a semiconductor device. For example, it includes a material, which has undergone the steps of forming an inorganic film, a resist underlayer film, a resist film, and the like on a semiconductor substrate in the method for manufacturing a semiconductor device as described above, and is used for the step of forming a resist pattern by irradiation of the resist film with a light or electron beam and subsequent development.

### (Method for manufacturing wafer for manufacturing semiconductor)

The photocurable resin composition according to the present invention as a wafer edge protective film-forming composition for manufacturing a semiconductor is applied, by spin coating, to a front surface edge and optionally a bevel portion and/or back surface edge of a wafer precursor for manufacturing a semiconductor obtained by one or more steps of the semiconductor device manufacturing process.

Thereafter, the semiconductor substrate may be baked. In this case, the means for baking is not particularly limited, and for example, a proximity bake furnace for securing a gap using a plurality of substrate support pins between a substrate and a hot plate is suitably used. A bake temperature is usually within the range of 40°C to 300°C and preferably 200 to 300°C for 1 to 30 minutes.

After the photocurable resin composition is applied, the protective film edge face may be subjected to a known treatment in the semiconductor manufacturing process such as edge bead removal or backrinsing.

### <Wafer for manufacturing semiconductor>

The wafer for manufacturing a semiconductor of the present invention is a wafer for manufacturing a semiconductor in which a wafer edge is protected, and is a wafer for manufacturing a semiconductor formed by applying the photocurable resin composition containing a polymer having a crosslinkable group and a solvent to a wafer edge.

### Examples

Hereinafter, the present invention will be described in more detail with reference to Synthesis Examples, Examples, and Comparative Examples, but the present invention is not limited only to the following Examples.

The weight average molecular weight of polymers described in the following Synthesis Examples and Comparative Synthesis Examples of the present specification is the result of the measurement by gel permeation chromatography (hereinafter, abbreviated as GPC). For the measurement, a GPC apparatus manufactured by Tosoh Corporation was used, and the measurement conditions and the like were as follows.
GPC column: Shodex KF803L, Shodex KF802, Shodex KF801 [registered trademark] (Showa Denko K. K.)
Column temperature: 40°C
Solvent: tetrahydrofuran (THF)
Flow rate: 1.0 ml/min
Standard sample: polystyrene (manufactured by Tosoh Corporation)

### <a. Synthesis of polymers and monomers>

### <Synthesis Example 1>

21 g of glycidyl methacrylate and 39 g of 2-hydroxypropyl methacrylate were dissolved in 242 g of propylene glycol monomethyl ether, and then the temperature was raised to 70°C. Thereafter, 0.6 g of azobisisobutyronitrile was added while maintaining the reaction solution at 70°C, and the mixture was allowed to react at 70°C for 24 hours to obtain a solution of a copolymerized polymer compound of glycidyl methacrylate and 2-hydroxypropyl methacrylate. GPC analysis showed that the obtained copolymerized polymer compound had a weight average molecular weight of 50,000 in terms of standard polystyrene. To 100 g of a solution containing 20 g of the polymer compound were added 10 g of 9-anthracene carboxylic acid, 0.3 g of benzyltriethylammonium chloride, and 41 g of propylene glycol monomethyl ether, and the mixture was allowed to react at 130°C for 24 hours, thereby obtaining a solution of a polymer compound of Formula (S1).

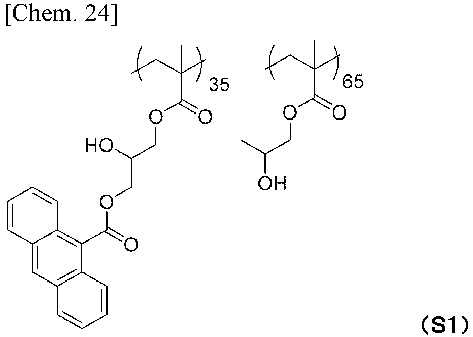

### <Synthesis Example 2>

10 g of a cresol novolac resin (product of Asahi-Ciba Co., Ltd., trade name ECN1299, weight average molecular weight 3,900) was added to and dissolved in 80 g of propylene glycol monomethyl ether. To the solution, 9.7 g of 9-anthracene carboxylic acid and 0.26 g of benzyltriethylammonium chloride were added, and the mixture was allowed to react at 105°C for 24 hours, thereby obtaining a resin compound of Formula (S2). GPC analysis showed that the obtained resin compound had a weight average molecular weight of 5,600 in terms of standard polystyrene.

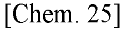

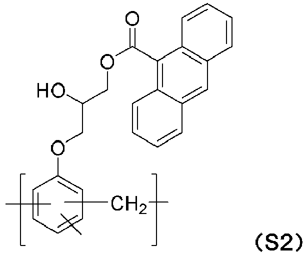

### <Synthesis Example 3>

6.6 g (0.039 mol) of γ-butyrolactone methacrylate, 6.6 g (0.046 mol) of hydroxypropyl methacrylate, 6.8 g (0.039 mol) of benzyl methacrylate, and 0.2 g of azobisisobutyronitrile were dissolved in 80.4 g of ethyl lactate, the inside of the flask was replaced with nitrogen, the temperature was raised to 70°C, and then the mixture was allowed to react for 24 hours, thereby obtaining a resin of Formula (S3).

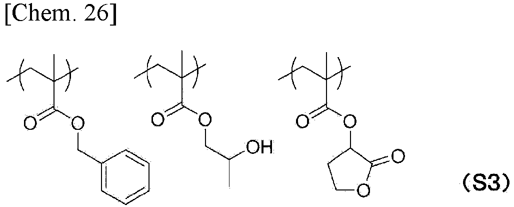

### <Synthesis Example 4>

5.0 g (0.018 mol) of 9-anthrylmethyl methacrylate, 4.8 g (0.034 mol) of hydroxypropyl methacrylate, and 0.2 g of 2,2'-azobis(isobutyric acid) dimethyl were dissolved in 40.2 g of propylene glycol monomethyl ether acetate, the inside of the flask was replaced with nitrogen, the temperature was raised to 70°C, and then the mixture was allowed to react for 24 hours, thereby obtaining a resin of Formula (S4).

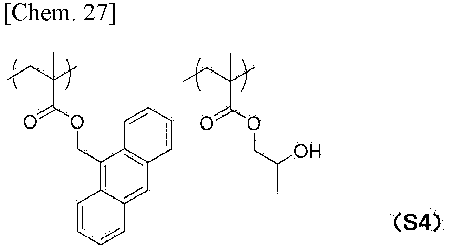

### <b. Preparation of composition>

### <Example 1 (composition 1), Example 2 (composition 2), and Example 3 (composition 3)>

To 1.2 g of a solution containing 0.24 g of each of the reaction products obtained in Synthesis Example 1, Synthesis Example 2, and Synthesis Example 4 was added 5.76 g of propylene glycol monomethyl ether, and the mixture was filtered using a polyethylene microfilter having a pore size of 0.10 µm, thereby preparing a photocurable resin composition.

### <Comparative Example 1>

To 1.2 g of a solution containing 0.24 g of the reaction product obtained in Synthesis Example 3 was added 5.76 g of propylene glycol monomethyl ether, and the mixture was filtered using a polyethylene microfilter having a pore size of 0.10 µm, thereby preparing a photocurable resin composition.

### <c. Test for elution into photoresist solvent>

Each of the photocurable resin compositions prepared in Example 1, Example 2, and Comparative Example 1 was applied onto a silicon wafer by a spinner. The composition was baked on a hot plate at 80°C for 1 minute, and then irradiated with light having a wavelength of 365 nm at 3 J/cm² by an i-line aligner (PLA-501, Canon Inc.) to form a photocured film (film thickness: 0.10 µm). The photocured film was immersed in a solvent used for a photoresist, for example, cyclohexanone. It was confirmed that the photocured films obtained using the compositions of Example 1 and Example 2 were insoluble in the solvent, but the photocured film obtained using the composition of Comparative Example 1 was dissolved by the solvent.

### <d. Measurement of optical parameters>

Each of the photocurable resin compositions prepared in Example 1, Example 2, and Comparative Example 1 was applied onto a silicon wafer by a spinner. The composition was baked on a hot plate at 80°C for 1 minute, and then irradiated with light having a wavelength of 365 nm at intensities of 0.3 J/cm² and 3 J/cm² by an i-line aligner (PLA-501, Canon Inc.) to form a photocured film (film thickness: 0.10 µm). Then, the refractive index (n value) and attenuation coefficient (k value) of these photocured films at a wavelength of 248 nm were measured using a spectroscopic ellipsometer. The results are shown below. (Notation in order of n/k)

As a result, for the photocured films of Example 1 and Example 2, the n and k values were changed, and a structural change was suggested, but for the photocured film of Comparative Example 1, there was almost no change in the value.

### [Table 1]

**Table 1**

| | No light irradiation | 0.3J/cm² | 3J/cm² |
|---|---|---|---|
| Example 1 | 1.50/0.53 | 1.53/0.36 | 1.64/0.14 |
| Example 2 | 1.57/0.65 | 1.62/0.48 | 1.75/0.25 |
| Comparative Example 1 | 1.62/0.00 | 1.63/0.00 | 1.63/0.00 |

### (e. Measurement of dry etching rate)

Each of the photocurable resin compositions prepared in Example 1, Example 2, and Comparative Example 1 was applied onto a silicon wafer by a spinner. The composition was baked on a hot plate at 80°C for 1 minute, and then irradiated with light having a wavelength of 365 nm at intensities of 0.3 J/cm² and 3 J/cm² by an i-line aligner (PLA-501, Canon Inc.) to form a photocured film (film thickness: 0.10 µm). Then, the dry etching rate (nm/min) of these photocured films was measured using an etcher (RIE-10NR) manufactured by Samco Inc. under the condition of using CF₄ as a dry etching gas.

Comparison with the dry etching rate of the photocured films of Example 1, Example 2, and Comparative Example 1 showed that, for the photocured films of Example 1 and Example 2, the etching rate was slightly decreased by light irradiation, and a structural change was suggested, but for the photocured film of Comparative Example 1, the value was not changed.

### [Table 2]

**Table 2**

| | No light irradiation | 0.3J/cm² | 3J/cm² |
|---|---|---|---|
| Example 1 | 28 | 27 | 26 |
| Example 2 | 21 | 20 | 19 |
| Comparative Example 1 | 33 | 33 | 33 |

| | | | |
|---|---|---|---|
| Unit is nm/min | | | |

### <f. Solvent resistance test in edge exposure>

Each of the photocurable resin compositions prepared in Example 1, Example 2, and Comparative Example 1 was applied onto a 12 inch silicon wafer by a spinner. The composition was baked on a hot plate at 80°C for 1 minute, and then the wafer edge was irradiated at 50 mJ/cm² by WEE of Lithiuspro (Tokyo Electron Limited.) to form a photocured film (film thickness: 0.30 µm). The photocured film was immersed in a solvent used for a photoresist, for example, OK73 thinner. It was confirmed that the photocured films of Example 1 and Example 2 were insoluble in the solvent, but the photocured film of Comparative Example 1 was dissolved by the solvent.

### Industrial Applicability

According to the present invention, it is possible to provide a photocurable resin composition useful in a lithography process in manufacturing a semiconductor, particularly useful for forming a wafer edge protective film for manufacturing a semiconductor.

In addition, it is possible to provide a photocured film of the composition, particularly a wafer edge protective film for manufacturing a semiconductor, a wafer for manufacturing a semiconductor including the photocured film, and a laminated substrate and a method for manufacturing a semiconductor device using the photocurable resin composition.

## Claims

1. A photocurable resin composition comprising a solvent and a polymer and/or compound, which contains a polycyclic aromatic hydrocarbon group.

2. The photocurable resin composition according to claim 1, wherein the polycyclic aromatic hydrocarbon group is derived from at least one member selected from the group consisting of naphthalene, anthracene, phenanthrene, and pyrene.

3. The photocurable resin composition according to claim 1, wherein the polymer is at least one member selected from the group consisting of polyvinyl alcohol, polyacrylamide, (meth)acrylic resin, polyamic acid, polyhydroxystyrene, polyhydroxystyrene derivative, copolymer of polymethacrylate and maleic anhydride, epoxy resin, phenol resin, novolac resin, polyimide, cellulose, cellulose derivative, starch, chitin, chitosan, gelatin, zein, sugar skeleton polymer compound, polyamide, polyethylene terephthalate, polycarbonate, polyurethane, and polysiloxane, each of which contains a polycyclic aromatic hydrocarbon group.

4. The photocurable resin composition according to claim 1, wherein the compound further contains a heterocyclic structure.

5. The photocurable resin composition according to claim 1, which is to be cured by light having a wavelength of 170 to 800 nm.

6. The photocurable resin composition according to claim 1, which is for forming a wafer edge protective film for manufacturing a semiconductor.

7. The photocurable resin composition according to claim 6, which has a viscosity of 100 cps or less at 25°C.

8. A photocured film of a coating film of the photocurable resin composition according to any one of claims 1 to 7.

9. A wafer edge protective film for manufacturing a semiconductor, which is a photocured product of a coating film of the photocurable resin composition according to claim 6 or 7.

10. The wafer edge protective film for manufacturing a semiconductor according to claim 9, which has a thickness of 1 nm to 10 µm.

11. The wafer edge protective film for manufacturing a semiconductor according to claim 9, which is for preventing metal contamination of a wafer edge.

12. A wafer for manufacturing a semiconductor, comprising at an end thereof the wafer edge protective film for manufacturing a semiconductor according to claim 9.

13. Use of the photocurable resin composition according to any one of claims 1 to 7 for forming a wafer edge protective film for manufacturing a semiconductor.

14. A method for manufacturing a laminated substrate, comprising the steps of:
applying the photocurable resin composition according to any one of claims 1 to 7 onto a substrate; and
exposing the applied composition.

15. The method for manufacturing a laminated substrate according to claim 14, wherein the substrate is a stepped substrate.

16. A method for manufacturing a semiconductor device, comprising the steps of:
applying the photocurable resin composition according to any one of claims 1 to 7 onto a substrate; and
exposing the applied composition.
